# EUROPÄISCHE PATENTSCHRIFT

(11) **EP 1 924 590 B1**
(45) Veröffentlichungstag und Bekanntmachung des Hinweises auf die Patenterteilung: **14.10.2009**
(21) Anmeldenummer: 06791659.3
(22) Anmeldetag: 25.08.2006
(51) Int. Cl.: C07F 15/00, H05B 33/14, C09K 11/06

(54) **METALLKOMPLEXE**
METAL COMPLEXES
COMPLEXES METALLIQUES

(30) Priorität: 12.09.2005 DE 102005043165
(43) Veröffentlichungstag der Anmeldung: 28.05.2008
(73) Patentinhaber: Merck Patent GmbH, 64293 Darmstadt (DE)
(72) Erfinder: BUESING, Arne, 65929 Frankfurt am Main (DE); FORTTE, Rocco, 65933 Frankfurt (DE); STOESSEL, Philipp, 60487 Frankfurt am Main (DE); VESTWEBER, Horst, 34630 Gilersberg-Winterscheid (DE); HEIL, Holger, 64295 Darmstadt (DE); PARHAM, Amir, 65929 Frankfurt/Main (DE)
(86) Internationale Anmeldenummer: PCT/EP2006/008346
(87) Internationale Veröffentlichungsnummer: WO 2007/031185

(56) Entgegenhaltungen:
- WO-A-02/068435

## Beschreibung

Die vorliegende Erfindung beschreibt neue Metallkomplexe, deren Verwendung in Elektrolumineszenzelementen und darauf basierende Displays.

Metallorganische Verbindungen, speziell Ir- und Pt-Verbindungen, finden Einsatz als funktionelle Materialien in einer Reihe verschiedenartiger Anwendungen, die im weitesten Sinne der Elektronikindustrie zugerechnet werden können, z. B. in organischen Elektrolumineszenzvorrichtungen. Der allgemeine Aufbau solcher Vorrichtungen ist beispielsweise in US 4,539,507 und US 5,151,629 beschrieben.

Eine Entwicklung, die sich in den letzten Jahren abzeichnet, ist der Einsatz metallorganischer Komplexe, die Phosphoreszenz statt Fluoreszenz zeigen (M. A. Baldo et al., Appl. Phys. Lett. 1999, 75, 4-6). Aus quantenmechanischen Gründen ist unter Verwendung metallorganischer Verbindungen als Phosphoreszenzemitter eine bis zu vierfache Energie- und Leistungseffizienz möglich. Ob sich diese Entwicklung durchsetzen wird, hängt davon ab, ob entsprechende Device-Kompositionen gefunden werden, die diese Vorteile (Triplett-Emission = Phosphoreszenz gegenüber Singulett-Emission = Fluoreszenz) auch in den OLEDs umsetzen können. Als wesentliche Bedingungen sind hier insbesondere eine hohe operative Lebensdauer und eine hohe thermische Stabilität der Komplexe zu nennen.

Allerdings gibt es bei OLEDs, die Triplettemission zeigen, immer noch erhebliche Probleme, die einer dringenden Verbesserung bedürfen. Dies gilt insbesondere auch für den Triplettemitter selbst. Die meisten in der Literatur bekannten Komplexe enthalten Liganden, die auf Phenylpyridin oder verwandten Strukturen basieren, die an Iridium oder Platin koordinieren (z. B. WO 02/068435, WO 04/026886). Komplexe basierend auf Phenylpyridin zeigen grüne Emission. Zur Erzeugung tiefroter Emission sind modifizierte Ligandenstrukturen nötig. So kann durch Verwendung von Phenylisochinolin als Ligand ein tiefrot emittierender Iridium-Komplex synthetisiert werden (WO 02/044189). Dieser hat jedoch für die technische Anwendung den entscheidenden Nachteil, dass er keine ausreichend hohe thermische Stabilität aufweist und daher nicht sublimationsstabil ist. Daher kann der Komplex nicht durch Sublimation gereinigt werden und auch bei der Deviceherstellung kann der Aufdampfprozess nur unter partieller Zersetzung des Komplexes und großen Verlusten durchgeführt werden. Weiterhin führt die partielle Zersetzung des Komplexes beim Aufdampfen zur Verunreinigung des Materials durch Zersetzungsprodukte, was in einer verringerten Lebensdauer resultiert. Zudem sind diese Komplexe nur sehr schwer in organischen Lösemitteln löslich, was die Reinigung der Komplexe bei der Herstellung, aber auch die Reinigung der Schattenmasken bei der Deviceherstellung erschwert. Auch die Verwendung derartiger bromierter Verbindungen als Monomere für die Herstellung von Polymeren ist aufgrund der geringen Löslichkeit der Verbindungen problematisch.

In WO 04/081017 werden rot emittierende Iridiumkomplexe mit polypodalen Liganden beschrieben, die gegenüber den oben genannten Komplexen basierend auf Phenylisochinolin als Liganden eine höhere thermische Stabilität aufweisen. In WO 05/033244 werden rot emittierende Iridiumkomplexe beschrieben, in denen der Ligand eine Brücke zwischen der Phenylgruppe und der Isochinolingruppe enthält, wodurch auch höhere thermische Stabilität erreicht wird. Dadurch konnte bereits ein deutlicher Fortschritt gegenüber den oben genannten Komplexen erzielt werden. Jedoch haben diese beiden Verbindungsklassen den Nachteil, dass die entsprechenden Liganden nur aufwändig in mehrstufigen Synthesen zugänglich sind, so dass hier weiterhin Verbesserungsbedarf besteht.

So ist es für die breite technische Anwendung nötig, für rote Emission Metallkomplexe zur Verfügung zu stellen, die einerseits gute Emissionseigenschaften (Effizienz, Emissionsfarbe, Lebensdauer), hohe thermische Stabilität und gute Löslichkeit in organischen Lösemitteln aufweisen, die andererseits aber auch synthetisch einfach zugänglich sind.

Überraschend wurde gefunden, dass neue Metallkomplexe, die Liganden basierend auf einem cyclischen Imin aufweisen, einfach synthetisch zugänglich sind und außerdem sehr gute Emissionseigenschaften und eine hohe thermische Stabilität aufweisen, wenn der Cyclus, der das Imin enthält, mindestens ein Sechsring ist. Diese Metallkomplexe sind weiterhin sehr gut in organischen Lösemitteln löslich. Die entsprechenden Liganden sind mit deutlich weniger Aufwand synthetisierbar als die in WO 05/033244 und WO 04/081017 beschriebenen Liganden. Insbesondere überraschend ist die Beobachtung, dass mit diesen Komplexen tiefrote Emission erreicht werden kann, obwohl der Ligand nicht durchgängig konjugiert ist, und obwohl mit Iminen, in denen der Cyclus ein Fünfring ist, nur orange Emission erzielt wird.

Iridiumkomplexe, die aromatische oder aliphatische offenkettige Imine als Liganden enthalten, sind in der Literatur bekannt (US 2003/0194580, US 2004/0241493). Diese Komplexe werden als gleichzeitig fluoreszierend und phosphoreszierend beschrieben und emittieren weißes oder weißliches Licht. Komplexe offenkettiger Imine sind also nicht zur Erzeugung roter Emission geeignet.

In WO 04/048395 werden Komplexe beschrieben, deren Ligand über ein offenkettiges Imin und ein Thiophen an das Iridium bindet. Auch diese Komplexe sind nicht zur Erzeugung roter Emission geeignet.

In WO 05/056715 werden cyclische Imin-Liganden beschrieben, in denen der Imin-Cyclus ein Fünfring ist. Diese Liganden leiten sich also vom Indol ab. Mit diesen Komplexen wird allerdings nur organgerote Emission im Bereich von CIE x/y 0.58/0.34 bis 0.64/0.34 erzielt, jedoch keine tiefrote Emission. Da das menschliche Augen in diesem Farbbereich sehr sensibel ist, haben kleine Änderungen hier, insbesondere im CIE-x-Wert, einen starken Einfluss auf die Farbwahrnehmung. Daher sind diese Komplexe nicht als rot emittierende Verbindungen in Vollfarbdisplays einsetzbar.

Gegenstand der vorliegenden Erfindung sind die Verbindungen gemäß Formel (1)

M(L)ₙ(L')ₘ(L")ₒ Formel (1)

enthaltend eine Teilstruktur M(L)ₙ gemäß Formel (2), 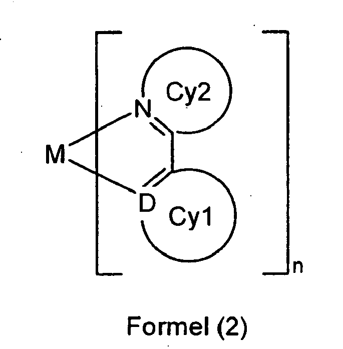 wobei für die verwendeten Symbole und Indizes gilt:
- M: ist ein Übergangsmetall;
- D: ist gleich oder verschieden bei jedem Auftreten ein sp²-hybridisiertes Kohlenstoffatom, das an M bindet, oder ein negativ geladenes Heteroatom, das an M bindet;
- Cy1: ist gleich oder verschieden bei jedem Auftreten ein Homo- oder Heterocyclus, der über D an M bindet, der durch R¹ substituiert sein kann und an den noch weitere aliphatische, aromatische oder heteroaromatische Cyclen ankondensiert sein können;
- Cy2: ist gleich oder verschieden bei jedem Auftreten ein Heterocyclus, der über N an M koordiniert, der durch R¹ substituiert sein kann und an den noch weitere aliphatische, aromatische oder heteroaromatische Cyclen ankondensiert sein können;
- R¹: ist gleich oder verschieden bei jedem Auftreten H, F, Cl, Br, I, CN, NO₂, OH, N(R²)₂, B(OR²)₂, CHO, OSO₂R², N(Ar)₂, C(=O)Ar, P(=O)(Ar)₂, S(=O)Ar, S(=O)₂Ar, CR²=CR²Ar, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²-, SO, SO₂ oder -CONR²- ersetzt sein können und wobei ein oder mehrere H-Atome durch F, Cl, Br, I oder CN ersetzt sein können, oder ein aromatisches oder heteroaromatisches Ring-system bzw. eine Aryloxy- oder Heteroaryloxygruppe mit 5 bis 30 aromatischen Ringatomen, oder eine Kombination aus zwei, drei oder vier dieser Gruppen; dabei können auch zwei oder mehrere Reste R¹ miteinander ein weiteres aliphatisches, aromatisches oder heteroaromatisches Ringsystem bilden;
- Ar: ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R¹ substituiert sein kann; dabei können auch zwei Reste Ar am selben Stickstoffatom durch eine Einfachbindung oder eine Brücke O, S, N(R²) oder C(R²)₂ miteinander verknüpft sein;
- R²: ist gleich oder verschieden bei jedem Auftreten H oder ein aliphatischer oder aromatischer Kohlenwasserstoffrest mit 1 bis 20 C-Atomen; dabei können mehrere Reste R² auch miteinander ein Ringsystem bilden;
- n: ist 1, 2 oder 3;
dabei sind L' und L" in Formel (1) monoanionische, zweizähnig chelatisierende Liganden; m und o sind gleich oder verschieden bei jedem Auftreten 0, 1 oder 2;
**dadurch gekennzeichnet, dass** der Cyclus Cy2 teilweise gesättigt ist und mindestens einen Sechsring darstellt.

Dabei gilt, dass n + m + o = 2 für quadratisch-planar koordinierte Metalle, beispielsweise Platin und Palladium, und n + m + o = 3 für oktaedrisch koordinierte Metalle, beispielsweise Iridium und Rhodium, ist.

Weiterhin ist es möglich, dass zwei oder drei Liganden L und/oder L' und/oder L" über die Reste R¹ zu einem polypodalen System bzw. zu einem Kryptanden verknüpft sind. Dabei kann die Verknüpfung sowohl an Cy1 wie auch an Cy2 erfolgen. Wie eine solche Verknüpfung erfolgen kann und welche Gruppen sich besonders als verknüpfende Einheiten eignen, ist beispielsweise in WO 04/081017, WO 05/042550, WO 05/113563 und WO 06/008069 beschrieben. Außerdem können die Cyclen Cy1 und Cy2 außer über die direkte kovalente Bindung noch über eine gemeinsame Gruppe R¹ zu einem weiteren Ringsystem verknüpft sein.

Die Verbindungen gemäß Formel (1) können neutral oder geladen sein. Bevorzugt sind neutrale Verbindungen.

Weiterer Gegenstand der Erfindung sind Verbindungen gemäß Formel (3), 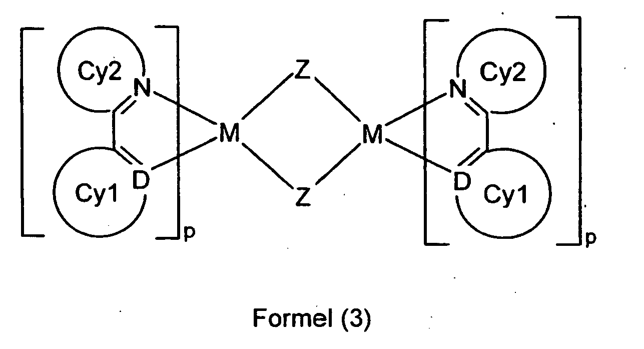 wobei die Symbole M, D, Cy1, Cy2, R¹ und R² dieselbe Bedeutung haben, wie oben beschrieben, und für die weiteren Symbole und Indizes gilt:
- Z: ist bei jedem Auftreten gleich oder verschieden F, Cl, Br, I, OH oder OR², bevorzugt Cl, Br oder OH, besonders bevorzugt Cl;
- p: ist 2 für ein oktaedrisch koordiniertes Metall M und ist 1 für ein quadratisch-planar koordiniertes Metall M;
**dadurch gekennzeichnet, dass** der Cyclus Cy2 teilweise gesättigt ist und mindestens einen Sechsring darstellt.

Unter Hybridisierung wird die Linearkombination von Atomorbitalen verstanden. So entstehen durch Linearkombination von einem 2s- und zwei 2p-Orbitalen drei äquivalente sp²-Hybridorbitale, die einen Winkel von 120° miteinander bilden. Das verbleibende p-Orbital ist zur Ausbildung einer π-Bindung, beispielsweise in einem aromatischen System, befähigt.

Eine Arylgruppe im Sinne dieser Erfindung enthält 6 bis 40 C-Atome; eine Heteroarylgruppe im Sinne dieser Erfindung enthält 2 bis 40 C-Atome und mindestens 1 Heteroatom, mit der Maßgabe, dass die Summe aus C-Atomen und Heteroatomen mindestens 5 ergibt. Die Heteroatome sind bevorzugt ausgewählt aus N, O und/oder S. Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin, Thiophen, etc., oder eine kondensierte Aryl- oder Heteroarylgruppe verstanden.

Ein aromatisches Ringsystem im Sinne dieser Erfindung enthält 6 bis 40 C-Atome im Ringsystem. Ein heteroaromatisches Ringsystem im Sinne dieser Erfindung enthält 2 bis 40 C-Atome und mindestens ein Heteroatom im Ringsystem, mit der Maßgabe, dass die Summe aus C-Atomen und Heteroatomen mindestens 5 ergibt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur einfache oder kondensierte Aryl- oder Heteroarylgruppen enthält, sondern in dem auch mehrere Aryl- oder Heteroarylgruppen durch eine kurze, nicht-aromatische Einheit (weniger als 10 % der von H verschiedenen Atome, bevorzugt weniger als 5 % der von H verschiedenen Atome), wie z. B. ein sp³-hybridisiertes C-, N- oder O-Atom, unterbrochen sein können. So sollen beispielsweise auch Systeme wie Biphenyl, 9,9'-Spirobifluoren, 9,9-Diarylfluoren, Triarylamin, Diarylether, etc. als aromatische Ringsysteme im Sinne dieser Erfindung verstanden werden.

Unter einem teilweise gesättigten Heterocyclus, wie in Cy2 darstellt, im Sinne der vorliegenden Erfindung soll ein Heterocyclus verstanden werden, der mindestens eine Gruppe im Cyclus enthält, welche vollständig gesättigt ist und daher nicht an einer π-Bindung und dadurch an der Ausbildung eines aromatischen Systems beteiligt ist. Weiterhin enthält er, wie oben abgebildet, mindestens eine Imingruppe, also eine ungesättigte Gruppe. Dabei ist es auch zulässig, wenn an dem teilweise gesättigten Heterocyclus noch ein aromatischer oder heteroaromatischer Cyclus ankondensiert ist. So ist beispielsweise Pyridin kein teilweise gesättigter Heterocyclus, da im Pyridin alle Gruppen, die den Ring aufbauen, am konjugierten π-Elektronensystem beteiligt sind. Ebenso sind beispielsweise Furan, Pyrrol und Thiophen keine teilweise gesättigten Heterocyclen, da dort das Heteroarom jeweils ein freies Elektronenpaar bereit stellt, welches zur der Ausbildung des aromatischen π-Elektronensystems beiträgt. Dagegen sind beispielsweise Dihydropyridin, Tetrahydropyridin, Dihydrochinolin und Dihydroisochinolin als teilweise gesättigte Heterocyclen zu bezeichnen.

Im Rahmen der vorliegenden Erfindung werden unter einer C₁- bis C₄₀-Alkylgruppe, in der auch einzelne H-Atome oder CH₂-Gruppen durch die oben genannten Gruppen substituiert sein können, besonders bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, n-Hexyl, Cyclohexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer C₁- bis C₄₀-Alkoxygruppe werden besonders bevorzugt Methoxy, Trifluormethoxy, Ethoxy, n-Propoxy, i-Propoxy, n-Butoxy, i-Butoxy, s-Butoxy, t-Butoxy oder 2-Methylbutoxy verstanden. Unter einem aromatischen oder heteroaromatischen System mit 1-30 C-Atomen, welches noch jeweils mit den oben genannten Resten R¹ substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Phenanthren, Pyren, Chrysen, Perylen, Fluoranthen, Tetracen, Pentacen, Benzpyren, Biphenyl, Biphenylen, Terphenyl, Terphenylen, Fluoren, Spirobifluoren, Dihydrophenanthren, Dihydropyren, Tetrahydropyren, cis- oder trans-Indenofluoren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Bevorzugt ist Cy1 ein aromatisches bzw. heteroaromatisches System.

Cy2 stellt mindestens einen Sechsring dar, also einen Sechsring oder einen größeren Ring. Bevorzugt stellt Cy2 einen Sechsring oder einen Siebenring dar, besonders bevorzugt einen Sechsring, an den jeweils noch weitere aliphatische, aromatische oder heteroaromatische Cyclen ankondensiert sein können.

Bevorzugt sind Verbindungen gemäß Formel (1), enthaltend eine Teilstruktur M(L)ₙ gemäß Formel (2a) oder Formel (2b), 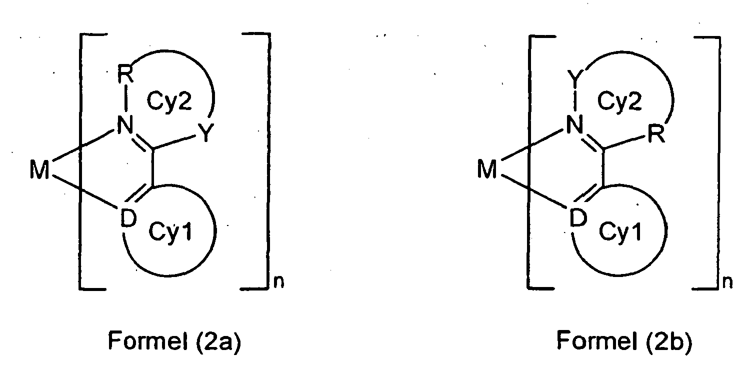 wobei M, Cy1, R¹, R², L', L", n, m und o dieselbe Bedeutung haben, wie oben beschrieben, und für die weiteren Symbole gilt:
- Y: ist gleich oder verschieden bei jedem Auftreten C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ oder C(R¹)₂-C(R¹)₂-N(R¹);
- Cy2: ist gleich oder verschieden bei jedem Auftreten ein Heterocyclus, der über N an M koordiniert, und stellt einen Sechsring oder einen Siebenring dar;
- D: ist bei jedem Auftreten gleich oder verschieden ein sp²-hybridisiertes C-Atom, das an M bindet, oder ein negativ geladenes Stickstoffatom, das an M bindet;
- R: ist gleich oder verschieden bei jedem Auftreten N(R¹), O, S, eine geradkettige bivalente Alkyl- oder Alkoxygruppe mit 1 bis 40 C-Atomen oder eine verzweigte oder cyclische bivalente Alkyl- oder Alkoxygruppe mit 3 bis 40 C-Atomen, wobei jeweils eine oder mehrere nicht benachbarte CH₂-Gruppen durch -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²-, SO, SO₂ oder -CONR²- ersetzt sein können und wobei ein oder mehrere H-Atome durch F, Cl, Br, I oder CN ersetzt sein können, oder ein bivalentes aromatisches oder heteroaromatisches Ringsystem bzw. eine bivalente Aryloxy- oder Heteroaryloxygruppe mit 5 bis 30 aromatischen Ringatomen, oder eine Kombination aus zwei, drei oder vier dieser Systeme.

Besonders bevorzugt sind Verbindungen enthaltend eine Teilstruktur gemäß Formel (2b), in der die ungesättigte Gruppe Y benachbart zum koordinierenden Stickstoffatom angeordnet ist.

Für blau und grün emittierende Verbindungen stellt die Gruppe R bevorzugt eine nicht-aromatische Gruppe, insbesondere eine Alkylgruppe gemäß der obigen Beschreibung dar.

Eine besonders bevorzugte Ausführungsform der vorliegenden Erfindung für rot emittierende Verbindungen sind Verbindungen der Formel (1a),

M(L)ₙ(L')ₘ(L")ₒ Formel (1a)

enthaltend mindestens eine Teilstruktur M(L)ₙ der Formel (2c), (2d), (2e) oder (2f), 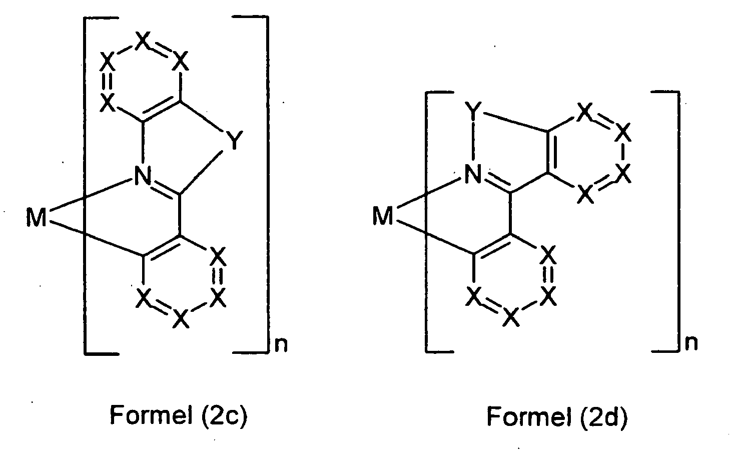 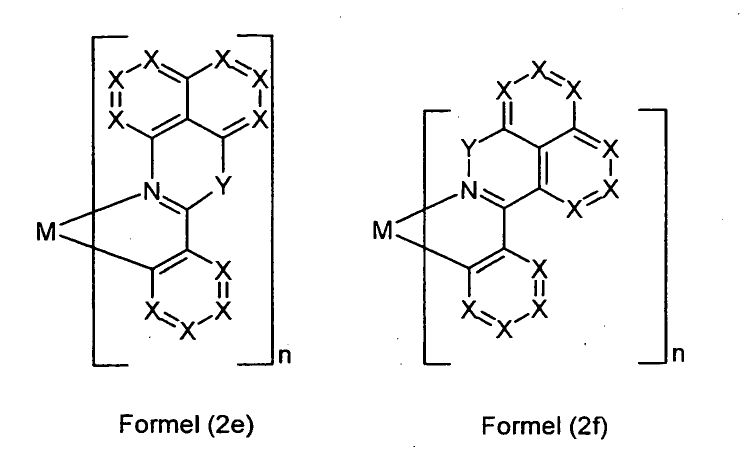 und gegebenenfalls enthaltend eine Teilstruktur M(L')ₘ der Formel (4), 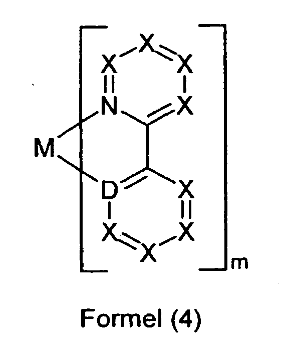 wobei M, D, Y, R, R¹, R², L", n, m und o dieselbe Bedeutung haben, wie oben beschrieben, und weiterhin gilt:
- Y: ist gleich oder verschieden bei jedem Auftreten C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ oder C(R¹)₂-C(R¹)₂-N(R¹) für Formel (2c) und (2d); und ist gleich oder verschieden bei jedem Auftreten C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ oder C(R¹)₂-C(R¹)₂-N(R¹) für Formel (2e) und (2f);
- X: ist gleich oder verschieden bei jedem Auftreten CR¹, N oder P;
oder (X-X) bzw. (X=X)
(also zwei benachbarte X) steht für NR¹, S oder O;
mit der Maßgabe, dass jeder der Cyclen, die Gruppen X enthalten, einen Fünf- oder einen Sechsring darstellt.

Erfindungsgemäße monoanionische, zweizähnige Liganden L" sind 1,3-Diketonate der Formel (5) abgeleitet von 1,3-Diketonen, 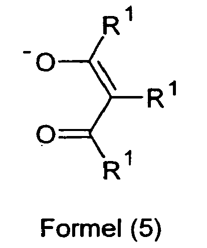 wobei R¹ dieselbe Bedeutung hat, wie oben beschrieben.

Dies sind beispielsweise Acetylaceton, Benzoylaceton, 1,5-Diphenylacetylaceton oder Bis(1,1,1-trifluoracetyl)methan. Weitere erfindungsgemäße monoanionische, zweizähnige Liganden L" sind 3-Ketonate abgeleitet von 3-Ketoestern, wie z. B. Acetessigsäureethylester, Carboxylate abgeleitet von Aminocarbonsäuren, wie z. B. Pyridin-2-carbonsäure, Chinolin-2-carbonsäure, Glycin, N,N-Dimethylglycin, Alanin, N,N-Dimethylalanin, Salicyliminate abgeleitet von Salicyliminen, wie z. B. Methylsalicylimin, Ethylsalicylimin, Phenylsalicylimin, sowie Borate Stickstoff-haltiger Heterocyclen, wie z. B. Tetrakis(1-imidazolyl)borat und Tetrakis(1-pyrazolyl)borat. Weiterhin geeignet sind Liganden, die über zwei Stickstoffatome binden, wovon eines neutral und das andere negativ geladen ist, beispielsweise Pyridylpyrazol, wie z. B. beschrieben in US 2002/134984.

Bevorzugt sind weiterhin Verbindungen gemäß Formel (3), die die oben ausgeführten Teilstrukturen gemäß Formel (2a) bis (2f) enthalten.

Bevorzugt sind sowohl die homoleptischen erfindungsgemäßen Verbindungen, bei denen für den Index n = 2 oder 3 gilt, wobei n = 3 für quadratisch-planare Komplexe nicht möglich ist. Besonders bevorzugt sind homoleptische Komplexe, bei denen alle vorhandenen Liganden gleich und auch gleich substituiert sind. Diese Bevorzugung homoleptischer Komplexe ist durch die leichtere synthetische Zugänglichkeit zu begründen.

Bevorzugt sind weiterhin die heteroleptischen erfindungsgemäßen Verbindungen, also Verbindungen, in denen der Index m und/oder o ungleich 0 ist. Die Bevorzugung heteroleptischer Komplexe mit nicht-ortho-metallierten Liganden vom Typ Acetylacetonat oder ähnlichen Coliganden liegt im geringeren Molekulargewicht der Komplexe begründet, welches wiederum zu einer geringeren Verdampfungstemperatur führt. Die Bevorzugung heteroleptischer Komplexe mit ortho-metallierten Coliganden liegt in der höheren Stabilität und damit höheren Lebensdauer der Komplexe. Außerdem ermöglichen heteroleptische Komplexe durch die größere Strukturvariabilität eine feinere Einstellung der physikalischen Eigenschaften der Komplexe.

Bevorzugt sind erfindungsgemäße Verbindungen, in denen M für Iridium, Platin, Palladium, Gold, Wolfram, Rhenium, Ruthenium oder Osmium steht, besonders bevorzugt für Iridium oder Platin, ganz besonders bevorzugt Iridium.

Bevorzugt sind erfindungsgemäße Verbindungen, in denen das Symbol Y, gleich oder verschieden bei jedem Auftreten, für C(R¹)₂-C(R¹)₂, C(R¹)₂-O, C(R¹)₂-N(R¹) oder C(R¹)₂-C(R¹)₂-C(R¹)₂ für die Teilstrukturen gemäß Formel (2c) und (2d) steht und für C(R¹)₂, P(=O)(R¹), C=O, C(R¹)₂-C(R¹)₂, C(R¹)₂-O, C(R¹)₂-N(R¹) oder C(R¹)₂-C(R¹)₂-C(R¹)₂ für die Teilstrukturen gemäß Formel (2e) und (2f).

Bevorzugt sind weiterhin erfindungsgemäße Verbindungen, bei denen für das Symbol D = C gilt.

Bevorzugt sind weiterhin Verbindungen gemäß Formel (1), (1a) bzw. (3), bei denen für das Symbol X = CR¹ oder N gilt, insbesondere X = CR¹.

Bevorzugt sind weiterhin Verbindungen gemäß Formel (1), (1a) bzw. (3), bei denen das Symbol R¹ für aufdampfbare Systeme bei jedem Auftreten gleich oder verschieden H, F, CN, Methyl, tert-Butyl, Phenyl, para-Tolyl, para-Xylyl, CF₃ oder eine ankondensierte cyclische Alkyl- oder Alkoxygruppe mit 1 bis 4 C-Atomen ist. Diese Bevorzugung ist durch die bessere Verdampfbarkeit dieser Systeme gegenüber anders substituierten Systemen zu begründen. Besonders bevorzugt ist in Cy1 und Cy2 die ortho-Position zur Koordination zum Metall M unsubstituiert, d. h. in dieser Position ist bevorzugt ein Wasserstoff gebunden.

Für Verbindungen gemäß Formel (1), (1a) bzw. (3), die aus Lösung verarbeitet werden und die daher eine gute Löslichkeit in organischen Lösemitteln aufweisen müssen, können die Substituenten R¹ auch größere Substituenten, z. B. Alkyl- und/oder Alkoxyketten mit vier und mehr C-Atomen, beispielsweise mit bis zu 10 C-Atomen, oder größere bzw. substituierte aromatische Substituenten, aufweisen. Dies gilt auch bei Verwendung dieser Komplexe zur Herstellung von Polymeren.

Die oktaedrischen Verbindungen gemäß Formel (1), (1a) bzw. (3) (also Verbindungen mit drei Liganden) können in facialer und meridionaler Form vorliegen. Gegenstand der Erfindung sind sowohl die reine faciale Form wie auch die reine meridionale Form des Komplexes oder auch Mischungen, in denen sowohl die faciale wie auch die meridionale Form vorliegen. Bevorzugt sind Verbindungen, die in facialer Form vorliegen. Die oktaedrischen Verbindungen gemäß Formel (1), (1a) bzw. (3) sind chiral. Gegenstand der Erfindung sind sowohl die reinen Enantiomere des Komplexes wie auch Mischungen, insbesondere das Racemat.

Die quadratisch-planaren Verbindungen gemäß Formel (1), (1a) bzw. (3) (also Verbindungen mit zwei Liganden) können in cis- und trans-Form vorliegen. Gegenstand der Erfindung sind sowohl die reine cis-Form wie auch die reine trans-Form des Komplexes oder auch Mischungen, in denen sowohl die cis- wie auch die trans-Form vorliegen.

Die Liganden, die in den erfindungsgemäßen Verbindungen zu Strukturen gemäß Formel (2) bzw. (2a) bis (2f) führen, können nach gängigen organisch-chemischen Verfahren hergestellt werden, wie in Schema 1 gezeigt:

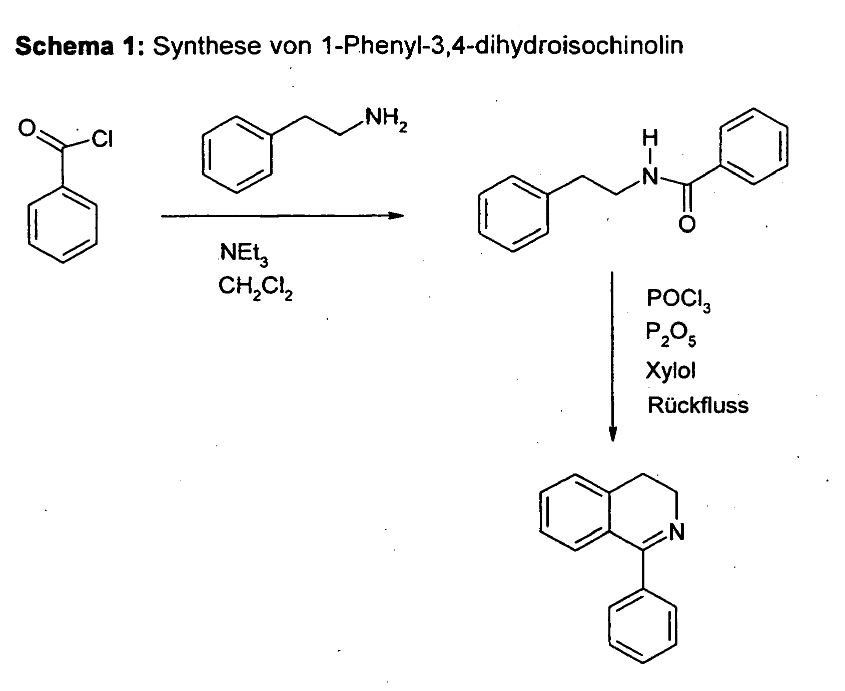

Zur Synthese des unsubstituierten Grundsystems wird Benzoesäurechlorid mit 2-Phenylethylenamin zum entsprechenden Amid umgesetzt und durch Reaktion mit POCl₃ und P₂O₅ zum 1-Phenyl-3,4-dihydroisochinolin cyclisiert. So ist das Grundgerüst in nur zwei Schritten aus kommerziell erhältlichen Ausgangsprodukten in sehr guter Ausbeute darstellbar.

Zur Variation und Optimierung der Komplexe sind unterschiedliche Substitutionen am Phenylringsystem wie auch am Dihydroisochinolinsystem möglich, wie in Schema 2 und 3 exemplarisch gezeigt. Dafür wird die Umsetzung entweder mit einem substituierten Benzoesäurederivat, wie hier mit 2-Naphthalincarbonsäure, und/oder mit einem substitierten 2-Phenylethylenamin durchgeführt.

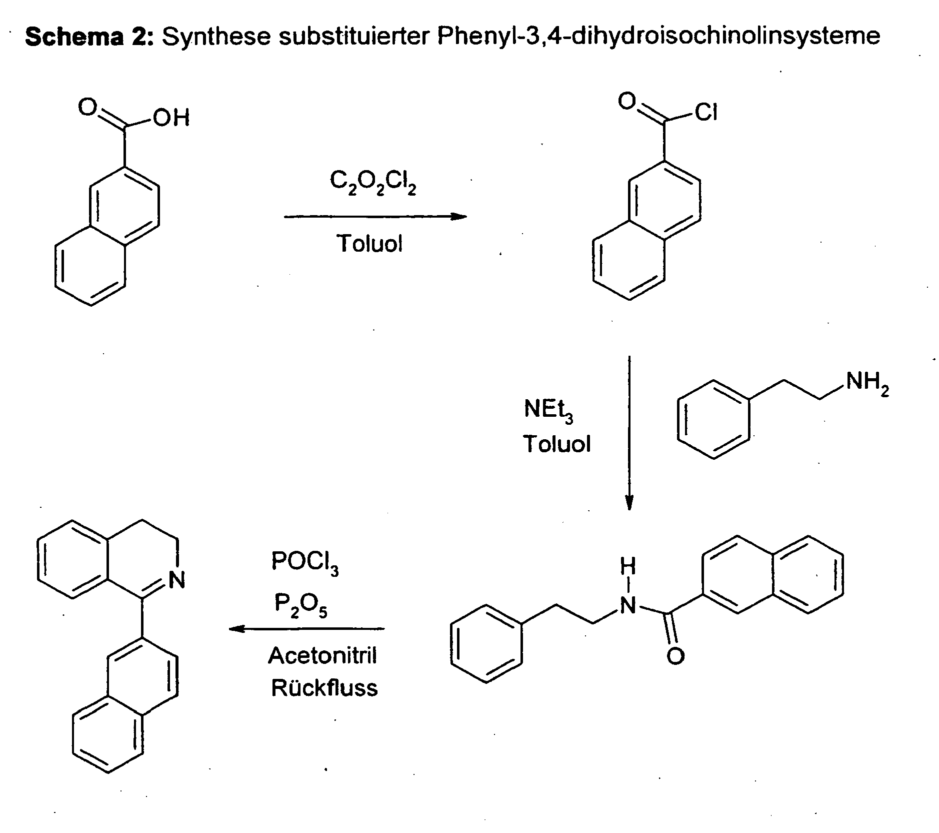

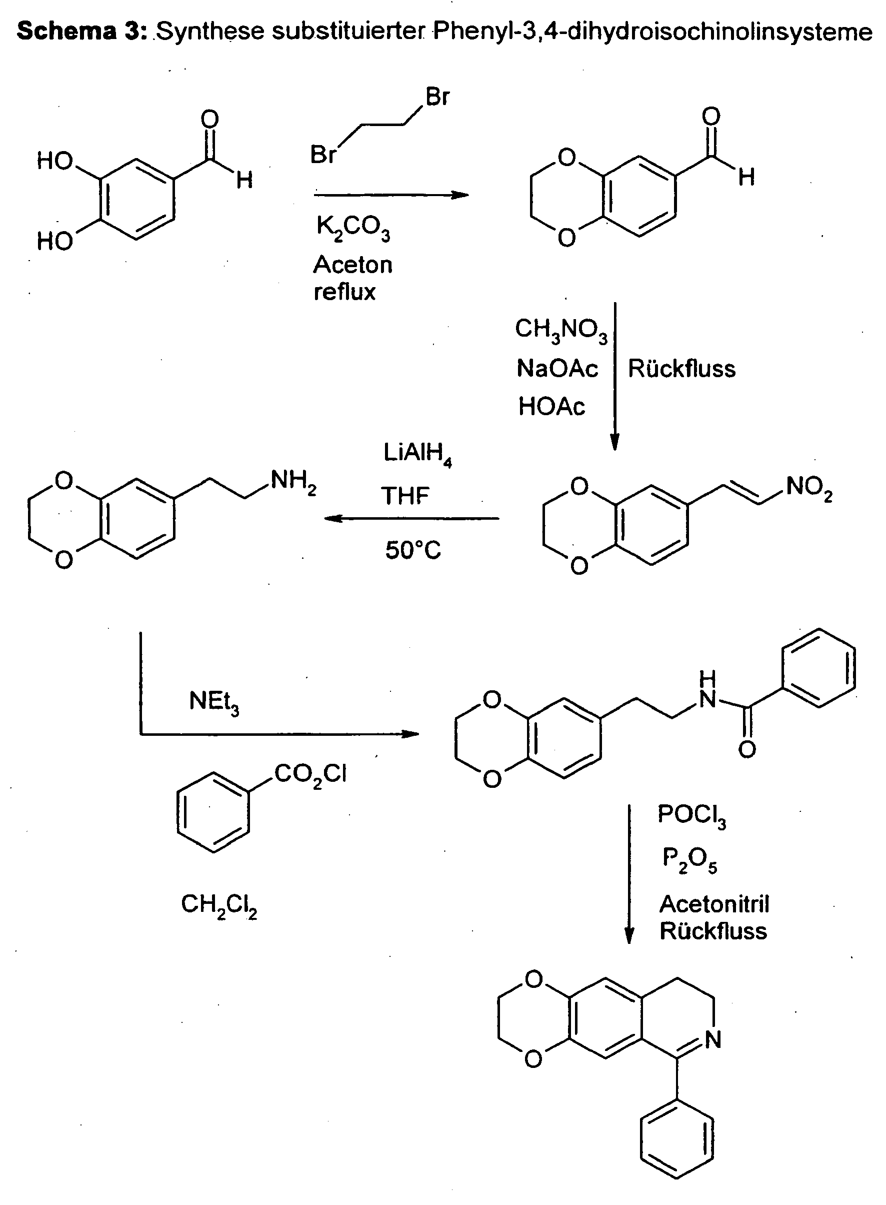

Ein weiterer Gegenstand der Erfindung ist die Verwendung von Liganden, die im Komplex zu Teilstrukturen gemäß Formel (2) bzw. Formel (2a) bis Formel (2f) führen, zur Herstellung der erfindungsgemäßen Verbindungen gemäß Formel (1) bzw. Formel (1 a) bzw. Formel (3).

Die erfindungsgemäßen Metallkomplexe sind prinzipiell durch verschiedene Verfahren darstellbar; es hat sich jedoch das im Folgenden beschriebene Verfahren als besonders gut geeignet herausgestellt. Ein weiterer Gegenstand der vorliegenden Erfindung ist daher ein Verfahren zur Herstellung der Metallkomplex-Verbindungen gemäß Formel (1) bzw. (1a) durch Umsetzung von Liganden, die im Komplex zu Strukturen gemäß Formel (2) bzw. (2a) bis (2f) führen mit Metallalkoholaten der Formel (6), mit Metallketoketonaten der Formel (7) oder ein- oder mehrkernigen Metallhalogeniden der Formel (8), (9) oder (10), 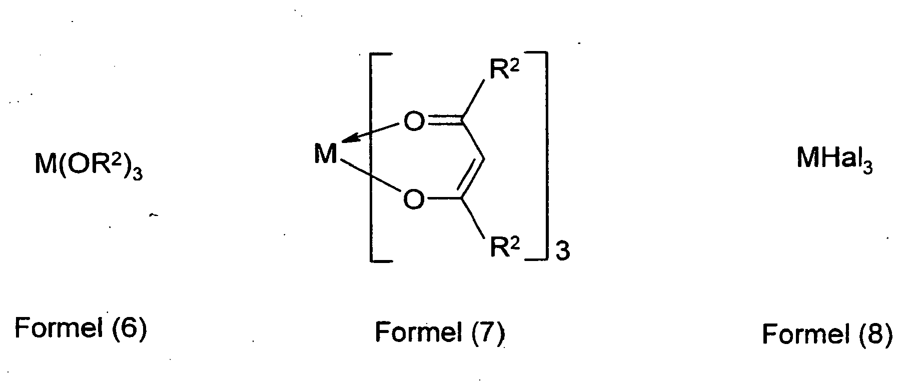 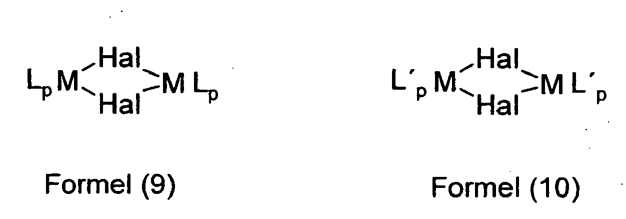 wobei die Symbole M, R¹ und p die oben angegebenen Bedeutungen haben und Hal = F, Cl, Br oder I ist.

Es können auch bevorzugt Iridiumverbindungen, die sowohl Alkoholat- und/oder Halogenid- und/oder Hydroxy- wie auch Ketoketonatreste tragen, verwendet werden. Diese Verbindungen können auch geladen sein. Bevorzugt sind Iridiumverbindungen, die gleichzeitig Halogenide und Ketoketonatreste tragen. Entsprechende Iridiumverbindungen, die als Edukte besonders geeignet sind, sind in WO 04/085449 offenbart, beispielsweise Na[Ir(acac)₂Cl₂].

Die Synthese der Komplexe wird bevorzugt so durchgeführt, wie in WO 02/060910 und in WO 04/085449 beschrieben. Überraschend wurde dabei gefunden, dass sich die erfindungsgemäßen Metallkomplexe unter ansonsten gleichen Reaktionsbedingungen deutlich schneller bilden als die Metallkomplexe gemäß dem Stand der Technik. Deshalb liegt im erfindungsgemäßen Verfahren die Reaktionszeit, abweichend von den oben genannten Verfahren gemäß dem Stand der Technik, bevorzugt im Bereich von 0.2 bis 60 h, besonders bevorzugt im Bereich von 0.5 bis 20 h, ganz besonders bevorzugt im Bereich von 1 bis 10 h. Heteroleptische Komplexe können beispielsweise auch gemäß WO 05/042548 oder gemäß der nicht offen gelegten Anmeldung DE 102005057963.9 synthetisiert werden. Heteroleptische Komplexe mit Acetylacetonat oder anderen nicht-ortho-metallierten Coliganden werden bevorzugt aus dem Chloro-verbrückten Dimer erhalten. Weiterhin kann die Synthese durch Einsatz von Mikrowellen beschleunigt werden, wie beispielsweise in WO 04/108738 beschrieben, wodurch sich die Reaktionszeit weiter verkürzt. Die Verbindungen können auch am Komplex funktionalisiert werden, beispielsweise durch Halogenierung, wie in WO 02/068435 beschrieben. Die halogenierten Komplexe können weiter umgesetzt werden, beispielsweise in einer Suzuki-Kupplung gemäß WO 04/026886 oder in einer Aminierungsreaktion gemäß WO 02/081488.

Durch diese Verfahren lassen sich die erfindungsgemäßen Verbindungen gemäß Formel (1) in hoher Reinheit, bevorzugt mehr als 99 % (bestimmt mittels ¹H-NMR und/oder HPLC) erhalten.

Beispiele für bevorzugte erfindungsgemäße Metallkomplexe sind homoleptische und heteroleptische Metallkomplexe, insbesondere Iridium- und Platinkomplexe, in denen mindestens ein Ligand eine beliebige Kombination aus den unten abgebildeten Strukturen **C1** bis **C8** für den Cyclus Cy1 und **N1** bis **N8** für den Cyclus Cy2 enthält. Dabei sind die Reste **R1** bis **R13** bevorzugt gleich oder verschieden gewählt aus der Gruppe bestehend aus H, F, Br, Methyl, tert-Butyl, Phenyl, para-Tolyl, para-Xylyl, B(OH)₂, Boronsäureglycolester, Boronsäurepinakolester, oder zwei benachbarte Reste **R1** bis **R13** bilden miteinander ein Ringsystem ausgewählt aus -(CH₂)₄-, -(CH₂)₃-, -O-(CH₂)₂-O- oder -(CH)₄-. Die Gruppe A im Teilcyclus **C8** bildet mit der Gruppe A im Teilcyclus **N8** ein Ringsystem und ist bevorzugt eine bivalente Gruppe, ausgewählt aus C(=O), C(CH₃)₂ und CF₂ oder stellt eine chemische Bindung dar. Dies sind jedoch nur spezifische Beispiele, und die vorliegende Erfindung ist nicht auf diese Beispiele beschränkt.

### Gruppen C1 bis C8 (in Cyclus Cy1):

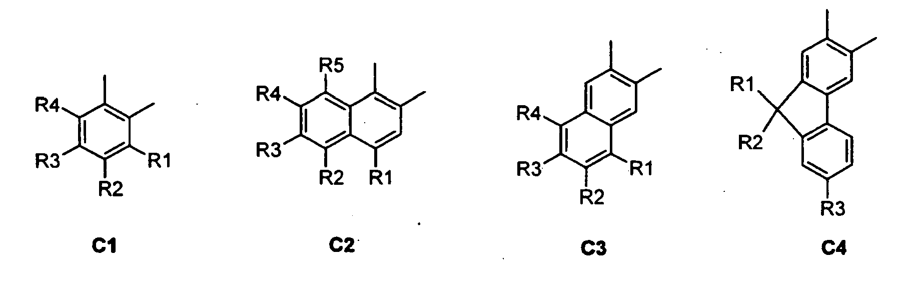

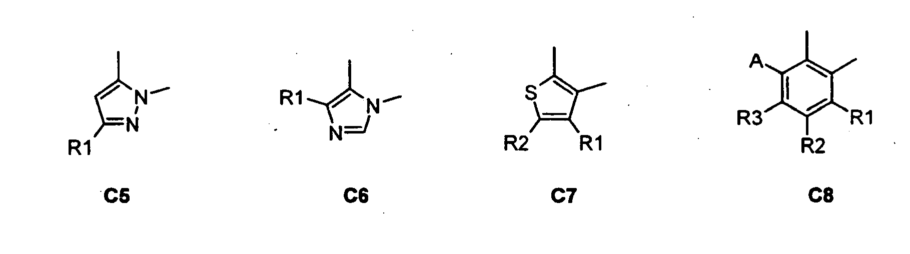

### Gruppen N1 bis N8 (in Cyclus Cy2):

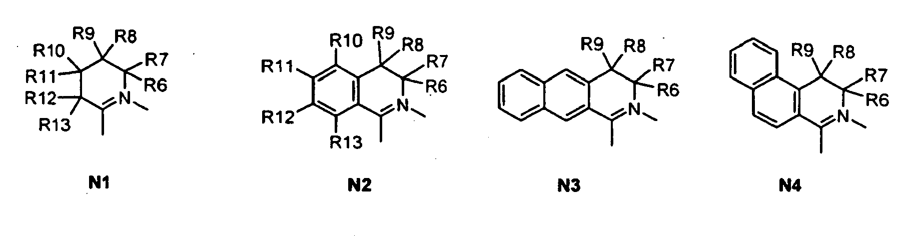

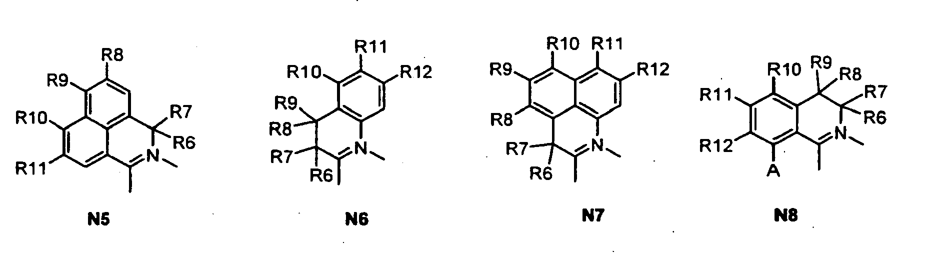

Die erfindungsgemäßen Verbindungen, die geeignete funktionelle Substituenten aufweisen, insbesondere Strukturen, die mit Brom oder Boronsäurederivaten substituiert sind, können auch als Comonomere zur Erzeugung entsprechender Oligomere, Polymere oder Dendrimere Verwendung finden. Die Polymerisation erfolgt dabei bevorzugt über die Brom- bzw. Boronsäurefunktionalität.

Weiterer Gegenstand der Erfindung sind daher Verbindungen gemäß Formel (1 b),

M(L)ₙ(L')ₘ(L")ₒ Formel (1b)

enthaltend eine Teilstruktur M(L)ₙ gemäß Formel (2g), 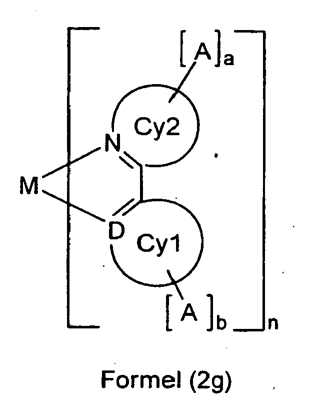 wobei M, D, Cy1, Cy2, R¹, R², L', L", n, m und o dieselbe Bedeutung haben, wie oben beschrieben, und weiterhin gilt:
- A: ist bei jedem Auftreten gleich oder verschieden eine Gruppe, die unter Palladium- oder Nickelkatalyse zu einer C-C- oder C-N-Kupplungsreaktion befähigt ist;
- a, b: ist bei jedem Auftreten gleich oder verschieden 0, 1, 2 oder 3, wobei a + b mindestens gleich 1 ist.

Der Substituent A ist bevorzugt ausgewählt aus der Gruppe bestehend aus Cl, Br, I, O-Tosylat, O-Triflat, O-SO₂R², B(OH)₂, B(OR²)₂ und Sn(R²)₃, besonders bevorzugt aus Br, O-Triflat und B(OR²)₂, wobei R² dieselbe Bedeutung hat, wie oben beschrieben.

Bevorzugt sind a und b bei jedem Auftreten gleich oder verschieden 0, 1 oder 2, besonders bevorzugt 0 oder 1, wobei a + b mindestens gleich 1 ist. Ganz besonders bevorzugt ist a + b = 1, insbesondere a = 0 und b = 1. Weiterhin bevorzugt ist die Gruppe A in para-Position zur Bindung an das Metall M (also in para-Position zur Gruppe D) gebunden.

Für die Verbindungen gemäß Formel (1 b) gelten dieselben Bevorzugungen, wie vorne bereits für Verbindungen gemäß Formel (1) bzw. Formel (1 a) ausgeführt.

Weiterer Gegenstand der Erfindung ist die Verwendung von Verbindungen gemäß Formel (1b) zur Synthese von Polymeren, Oligomeren oder Dendrimeren. Diese Polymere, Oligomere und Dendrimere können konjugiert, teilkonjugiert oder nicht-konjugiert sein.

Abhängig davon, ob die Gruppe A einmal, zweimal oder dreimal oder öfter im Komplex vorhanden ist, stellt der Komplex eine Endgruppe im Polymer dar, oder er wird linear in die Polymerkette eingebaut, oder er stellt einen Verzweigungspunkt der Polymerkette, Oligomers bzw. des Dendrimers dar. Weiterhin kann der Komplex auch bei geeigneter Substitution eine Seitenkette einer linearen oder verzweigten Polymerkette darstellen.

Weiterer Gegenstand der Erfindung sind somit Oligomere, Polymere oder Dendrimere, enthaltend eine oder mehrere der Verbindungen gemäß Formel (1) bzw. Formel (1a), wobei mindestens einer der oben definierten Reste R¹ bzw. R², bevorzugt R¹, eine Bindung zum Polymer oder Dendrimer darstellt. Diese Oligomere, Polymere oder Dendrimere können konjugiert, teilkonjugiert oder nicht-konjugiert sein. Für Einheiten gemäß Formel (1) bzw. Formel (1 a) gelten in Polymeren und Dendrimeren dieselben Bevorzugungen, wie oben bereits beschrieben. Dabei beträgt der Anteil der Einheiten gemäß Formel (1) bzw. Formel (1a) im Polymer zwischen 0.01 und 50 mol%, bevorzugt zwischen 0.1 und 30 mol%, besonders bevorzugt zwischen 0.2 und 10 mol%, ganz besonders bevorzugt zwischen 0.5 und 3 mol%.

Die oben genannten Oligomere, Polymere und Dendrimere zeichnen sich durch ihre gute Löslichkeit in organischen Lösemitteln und hohe Effizienz und Stabilität in organischen elektrolumineszierenden Vorrichtungen aus.

Bevorzugte Comonomere sind gewählt aus der Gruppe, bestehend aus Fluorenen (z. B. gemäß EP 842208 oder WO 00/22026), Spirobifluorenen (z. B. gemäß EP 707020, EP 894107 oder EP 04028865.6), Dihydrophenanthrenen (z. B. gemäß WO 05/014689), Indenofluorenen (z. B. gemäß WO 04/041901 und WO 04/113412), Phenanthrenen (z. B. gemäß WO 05/104264 oder DE 102005037734.3), Para-phenylenen (z. B. gemäß WO 92/18552), Carbazolen (z. B. gemäß WO 04/070772 oder WO 04/113468), Ketonen (z. B. gemäß WO 05/040302), Silanen (z. B. gemäß WO 05/111113) oder Thiophenen (z. B. gemäß EP 1028136) oder auch verschiedene dieser Einheiten. Dabei können die erfindungsgemäßen Einheiten entweder in die Seitenkette oder in die Hauptkette des Polymers eingebaut werden oder können auch Verzweigungspunkte der Polymerketten (z. B. gemäß WO 06/003000) oder Endgruppen der Polymerkette darstellen.

Weiterhin ist es bevorzugt, wenn die Polymere, Oligomere bzw. Dendrimere Wiederholeinheiten enthalten, die zum Transport von Löchern oder zum Transport von Elektronen geeignet sind.

Als Lochtransporteinheiten eignen sich insbesondere aromatische Amine oder Phosphine oder elektronenreiche Heterocyclen. Diese sind bevorzugt ausgewählt aus der Gruppe der substituierten oder unsubstituierten Triarylamine, Benzidine, N,N,N',N'-Tetraaryl-para-phenylendiamine, Triarylphosphine, Phenothiazine, Phenoxazine, Dihydrophenazine, Thianthrene, Dibenzo-*p*-dioxine, Phenoxathiine, Carbazole, Azulene, Thiophene, Pyrrole, Furane und weiteren O-, S- oder N-haltigen Heterocyclen mit hoch liegendem HOMO (HOMO = höchstes besetztes Molekülorbital). Diese Einheiten können in die Hauptkette oder in die Seitenkette des Polymers eingebaut werden. Je nach Struktur ist auch das Polymergrundgerüst und/oder der Metallkomplex in der Lage, ausreichend gut Löcher zu leiten, so dass nicht zwangsläufig die Einheiten anwesend sein müssen. Wenn Lochtransporteinheiten vorhanden sind, beträgt ihr Anteil bevorzugt zwischen 1 und 30 mol%, bevorzugt zwischen 3 und 20 mol%, besonders bevorzugt zwischen 6 und 15 mol%.

Als Elektronentransporteinheiten eignen sich insbesondere elektronenarme Aromaten oder Heterocyclen. Diese sind bevorzugt ausgewählt aus der Gruppe der substituierten oder unsubstituierten Pyridine, Pyrimidine, Pyridazine, Pyrazine, Triazine, Oxadiazole, Chinoline, Chinoxaline oder Phenazine, aber auch Verbindungen wie Triarylborane und weiteren O-, S- oder N-haltigen Heterocyclen mit niedrig liegendem LUMO (LUMO = niedrigstes unbesetztes Molekülorbital). Je nach Struktur ist auch das Polymergrundgerüst und/oder der Metallkomplex in der Lage, ausreichend gut Elektronen zu leiten, so dass nicht zwangsläufig diese Einheiten vorhanden sein müssen.

Es ist besonders bevorzugt, wenn die Polymere weiterhin Strukturelemente enthalten, welche den Übergang vom Singulett- zum TriplettZustand und damit die Elektrophosphoreszenzeigenschaften verbessern. Hierfür kommen beispielsweise Carbazoleinheiten in Frage, wie in WO 04/070772 und WO 04/113468 beschrieben, aber beispielsweise auch Keto-, Phosphinoxid-, Sulfoxid- oder Sulfon-Einheiten, wie in WO 05/040302 beschrieben, oder Silaneinheiten, wie in WO 05/111113 beschrieben. Diese Einheiten sind also bevorzugt ausgewählt aus der Gruppe der Carbazoleinheiten, der überbrückten Carbazoleinheiten, der Keto-, Phosphinoxid-, Sulfoxid- oder Sulfon-Einheiten und der Silan-einheiten. Dabei weisen Carbazoleinheiten lochtransportierende Eigenschaften auf. Keto-, Phosphinoxid-, Sulfoxid- und Sulfon-Einheiten weisen elektronentransportierende Eigenschaften auf. Wenn Keto-, Phosphinoxid-, Sulfoxid- oder Sulfon-Einheiten vorhanden sind, beträgt deren Anteil bevorzugt zwischen 1 und 30 mol%, besonders bevorzugt zwischen 3 und 20 mol%, ganz besonders bevorzugt zwischen 5 und 15 mol%.

Weiterhin können die erfindungsgemäßen Verbindungen gemäß Formel (1 b), die durch Halogene oder die anderen oben genannten funktionellen Gruppen A funktionalisiert sind, auch durch gängige Reaktionstypen weiter funktionalisiert werden und so zu erweiterten Verbindungen gemäß Formel (1) umgesetzt werden. Hier ist als Beispiel die Funktionalisierung mit Arylboronsäuren gemäß Suzuki oder mit Aminen gemäß Hartwig-Buchwald zu nennen.

Die erfindungsgemäßen Verbindungen, Oligomere, Polymere, Dendrimere oder erweiterten Verbindungen gemäß Formel (1) finden Verwendung als aktive Komponenten in elektronischen Bauteilen, wie z. B. in organischen Elektrolumineszenzvorrichtungen (OLEDs, PLEDs), organischen integrierten Schaltungen (O-ICs), organischen Feld-Effekt-Transistoren (O FETs), organischen Dünnfilmtransistoren (O-TFTs), organischen Solarzellen (O-SCs), organischen lichtemittierenden Transistoren (O-LETs), organischen Feld-Quench-Devices (O-FQDs), lichtemittierenden elektrochemischen Zellen (LECs), organischen Photorezeptoren (O-PCs) oder organischen Laserdioden (O-Laser).

Gegenstand der vorliegenden Erfindung ist also weiterhin die Verwendung der erfindungsgemäßen Verbindungen gemäß Formel (1), der erfindungsgemäßen Oligomere, Polymere und Dendrimere und entsprechender erweiterter Verbindungen gemäß Formel (1) als aktive Komponente in organischen elektronischen Bauteilen, insbesondere als emittierende Verbindung.

Weiterer Gegenstand der Erfindung sind elektronische Bauteile, ausgewählt aus der Gruppe der organischen und polymeren Elektrolumineszenzvorrichtungen (OLEDs, PLEDs), organischen Feld-Effekt-Transistoren (O-FETs), organischen Dünnfilmtransistoren (O-TFTs), organischen lichtemittierenden Transistoren (O-LETs), organischen integrierten Schaltungen (O-ICs), organischen Solarzellen (O-SCs), organischen Feld-Quench-Devices (O-FQDs), lichtemittierenden elektrochemischen Zellen (LECs), organischen Photorezeptoren (O-PCs) und organischen Laserdioden (O-Laser), insbesondere organische und polymere Elektrolumineszenzvorrichtungen, enthaltend eine oder mehrere erfindungsgemäße Verbindungen gemäß Formel (1), erfindungsgemäße Oligomere, Polymere und Dendrimere und entsprechende erweiterte Verbindungen gemäß Formel (1), insbesondere als emittierende Verbindung.

Bevorzugt werden die erfindungsgemäßen Verbindungen als emittierende Verbindungen in einer emittierenden Schicht in einer organischen oder polymeren Leuchtdiode eingesetzt. Insbesondere wenn es sich um niedermolekulare erfindungsgemäße Verbindungen handelt, werden diese üblicherweise zusammen mit einem Matrixmaterial eingesetzt. Dabei kann das Matrixmaterial sowohl niedermolekular, wie auch oligomer oder polymer sein. Copolymere können sowohl als Reinsubstanz wie auch als Blend mit anderen Polymeren und/oder mit niedermolekularen Verbindungen verwendet werden.

Bevorzugte Matrixmaterialien sind solche auf Basis von Carbazolen, beispielsweise CBP (Bis(carbazolyl)biphenyl), aber auch andere Materialien enthaltend Carbazol oder Carbazol-Derivate, z. B. gemäß WO 00/057676, EP 1202358 und WO 02/074015. Auch polymere Carbazole, beispielsweise PVK oder solche wie beschrieben in WO 04/070772 oder WO 04/113468, sind möglich. Bevorzugt sind weiterhin Ketone und Imine, wie beispielsweise in WO 04/093207 und WO 05/040302 beschrieben, insbesondere solche, basierend auf Spirobifluoren, und Phosphinoxide, Phosphinselenide, Phosphazene, Sulfoxide und Sulfone, wie beispielsweise in WO 05/003253 und WO 05/040302 beschrieben, insbesondere solche, basierend auf Spirobifluoren. Weiterhin bevorzugt sind Silane, z. B. gemäß WO 05/111172, polypodale Metallkomplexe, z. B. gemäß WO 04/081017, und Oligophenylene basierend auf Spirobifluorenen, z. B. gemäß EP 676461 und WO 99/40051. Besonders bevorzugte Matrixmaterialien sind Ketone, Phosphinoxide, Sulfoxide und Sulfone. Ganz besonders bevorzugt sind Ketone und Phosphinoxide.

Die erfindungsgemäßen Verbindungen weisen die folgenden Vorteile gegenüber Verbindungen gemäß dem Stand der Technik auf:
1. Die erfindungsgemäßen Verbindungen zeichnen sich durch eine höhere Temperaturstabilität aus. So können die niedermolekularen Verbindungen nicht nur bei der Herstellung der organischen elektronischen Vorrichtung im Hochvakuum unzersetzt verdampft werden, sondern sie können auch zur Reinigung der Verbindungen mit größerer Rate bei höherer Temperatur unzersetzt sublimiert werden. Dadurch ist die ressourcenschonende Nutzung von Verbindungen dieser seltenen Metalle möglich.
2. Die Liganden der erfindungsgemäßen Verbindungen sind einfach in wenigen Schritten und mit sehr hohen Ausbeuten zugänglich, während die Liganden für rot emittierende, thermisch stabile Materialien bisher nur in aufwändigen vielstufigen Synthesen zugänglich waren.
3. Im Vergleich zu cyclischen Iminkomplexen mit Indol-Liganden gemäß dem Stand der Technik zeichnen sich die erfindungsgemäßen Komplexe durch eine bathochrom verschobene Emission aus. So sind die erfindungsgemäßen Komplexe im Gegensatz zu Komplexen gemäß dem Stand der Technik zu tiefroter Emission befähigt, was ihre Anwendung in Vollfarbdisplays ermöglicht.
4. Die Metallkomplexe bilden sich bei der Synthese deutlich schneller als die Komplexe gemäß dem Stand der Technik, was einen technischen Vorteil darstellt.
5. Die erfindungsgemäßen Verbindungen zeichnen sich durch eine gute Löslichkeit in organischen Lösungsmitteln aus, was ihre Reinigung durch gängige Verfahren wie Umkristallisation oder Chromatographie erheblich erleichtert. Damit sind die Verbindungen auch aus Lösung durch Beschichtungs- oder Drucktechniken verarbeitbar. Auch bei der üblichen Verarbeitung durch Verdampfen ist diese Eigenschaft von Vorteil, da so die Reinigung der Anlagen bzw. der eingesetzten Schattenmasken erheblich erleichtert wird.
6. Die gute Löslichkeit der erfindungsgemäßen Verbindungen ist auch ein Vorteil, wenn diese Verbindungen in Polymere oder Oligomere einpolymerisiert werden sollen. Die Polymerisationsreaktion mit Monomeren gemäß dem Stand der Technik ist durch die geringe Löslichkeit der Komplexe nur schwer möglich. Dagegen lässt sich die Polymerisation mit den erfindungsgemäßen Verbindungen deutlich leichter durchführen. Dies gilt auch für weitere Umsetzungen der Komplexe.

Die vorliegende Erfindung wird durch die folgenden Beispiele näher ausgeführt, ohne sie darauf beschränken zu wollen. Der Fachmann kann aus den Schilderungen ohne erfinderisches Zutun weitere erfindungsgemäße Verbindungen herstellen bzw. das erfindungsgemäße Verfahren anwenden.

### Beispiele:

Die nachfolgenden Synthesen werden, sofern nicht anders angegeben, unter einer Schutzgasatmosphäre in getrockneten Lösungsmitteln durchgeführt. Die Edukte können von ABCR, Fluka oder Aldrich bezogen werden.

### Beispiel 1: Fac-tris[1-phenyl-3,4-dihydroisochinolin-C²,N]iridium(III), Komplex E1

### a) Synthese von N-(2-Phenylethyl)benzamid

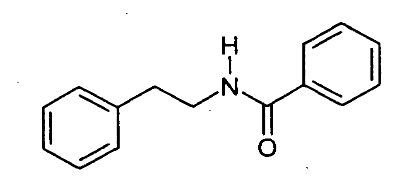

Zu einer Lösung aus 186.5 mL (1.49 mol) 2-Phenylethylamin und 210.5 mL (1.51 mol, 1.02 Äq.) Triethylamin in 300 mL Methylenchlorid wird bei 0 °C eine Lösung aus 171.7 mL Benzoylchlorid und 150 mL Methylenchlorid getropft. Es wird 16 h gerührt, wobei man auf Raumtemperatur kommen lässt. Der anfallende Feststoff wird in ausreichend Methylenchlorid gelöst und mehrfach mit Wasser gewaschen. Die organische Phase wird über MgSO₄ getrocknet und unter Vakuum zur Trockene eingeengt. Es werden 271 g (1.20 mol) eines weißen Feststoffes mit einer Reinheit von > 99.9 % erhalten. Die Ausbeute entspricht 81 % der Theorie.

### b) Synthese von 1-Phenyl-3,4-dihydroisochinolin

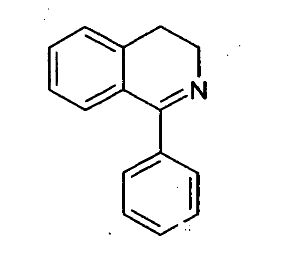

Zu einer Lösung von 100.0 g (446 mmol) N-(2-Phenylethyl)benzamid in 375 mL Xylol werden unter Rühren 75.5 g (532 mmol, 1.2 Äq.) P₂O₅ gegeben. Anschließend wird mit 124.1 mL (1.34 mol, 3.0 Äq.) POCl₃ versetzt und die Reaktionsmischung unter DC-Kontrolle unter Rückfluss erhitzt. Nach vollständigem Umsatz wird die Reaktionslösung heiß auf Eis gegossen und vorsichtig mit 20 %iger NaOH auf pH = 12 eingestellt. Dabei fällt Phosphat aus, welches durch Zugabe von Wasser in Lösung gebracht wird. Das Produkt wird anschließend mit Toluol extrahiert, mit 1N HCl in das Hydrochlorid überführt und mit ausreichend Wasser extrahiert. Die wässrige Phase wird mit 20 %iger NaOH unter Eiskühlung wiederum basisch gestellt, das Reaktionsprodukt mit Toluol extrahiert, über MgSO₄ getrocknet und unter Vakuum zur Trockene eingeengt. Man erhält 89.7 g (432.9 mmol) eines viskosen gelben Öls, entsprechend 97 % der Theorie.

### c) Synthese von Fac-Tris[1-phenyl-3,4-dihydroisochinolin-C²,N]iridium(III)

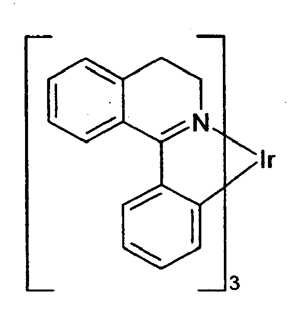

1.05 g (5 mmol, 10 Äq.) 1-Phenyl-3,4-dihydroisochinolin und 245 mg (0.5 mmol) Na[Ir(acac)₂Cl₂] werden in 10 mL Ethylenglykol gelöst und 4 h bei 180 °C gerührt. Anschließend wird auf RT abgekühlt und der Feststoff abgesaugt. Es wird mit Ethanol nachgewaschen und trocken gesaugt. Man erhält 244 mg (0.3 mmol) eines roten Feststoffes, entsprechend 60 % der Theorie.

Photolumineszenz (10⁻⁵ M in CH₂Cl₂): CIE x / y = 0.66 / 0.34.

### Beispiel 2: Deviceaufbau

Die Herstellung der OLEDs erfolgt nach einem allgemeinen Verfahren, das im Einzelfall auf die jeweiligen Gegebenheiten (z. B. Schichtdickenvariation zur Optimierung der Effizienz bzw. der Farbe) angepasst wird. Erfindungsgemäße Elektrolumineszenzvorrichtungen können wie beispielsweise in WO 05/003253 oder WO 04/058911 beschrieben dargestellt werden.

Die folgenden Beispiele zeigen die Ergebnisse verschiedener OLEDs mit Phosphoreszenzemittern, wobei erfindungsgemäße Verbindungen als Emitter eingesetzt werden. Als Vergleichsmaterial gemäß dem Stand der Technik wird Ir(piq)₃ verwendet. Der grundlegende Aufbau, die verwendeten Materialien und Schichtdicken sind esseren Vergleichbarkeit identisch. Gemäß dem o. g. allgemeinen Verfahren werden phosphoreszierende OLEDs mit folgendem Aufbau erzeugt:

| | |
|---|---|
| Lochinjektion (HIL) | 10 nm 2,2',7,7'-Tetrakis(di-para-tolylamino)spiro-9,9'-bifluoren |
| Lochtransport (HTL) | 30 nm NPB (N-Naphthyl-N-phenyl-4,4'-diamino-biphenyl) |
| Emission (EML) | Matrix **M**: Bis(9,9'-spirobifluoren-2-yl)keton (aufgedampft, synthetisiert nach WO 2004/093207) Emitter **E1** bzw. Ir(piq)₃ (10 % Dotierung, aufgedampft) |
| Lochblocker (HBL) | BAIq (bezogen von SynTec, Bis(2-methyl-8-hydroxychinolinato)-(4-phenyl-phenolato)aluminium(III)) |
| Elektronenleiter (ETL: | AlQ₃ (bezogen von SynTec, (Tris(8-hydroxy-chinolinato)aluminium(III)) |
| Kathode | 1 nm LiF, darauf 150 nm Al. |

Diese noch nicht optimierten OLEDs werden standardmäßig charakterisiert; hierfür werden die Elektrolumineszenzspektren, die Effizienz (gemessen in cd/A) in Abhängigkeit der Helligkeit und die Lebensdauer bestimmt. Als Lebensdauer wird die Zeit definiert, nach der die Anfangshelligkeit der OLED bei einer konstanten Anfangsleuchtdichte von 1000cd/m² auf die Hälfte abgesunken ist.

In Tabelle 1 sind die Ergebnisse der erfindungsgemäßen OLEDs enthaltend **E1** als Emitter und einer OLED enthaltend Ir(piq)₃ gemäß dem Stand der Technik zusammengestellt, wobei lediglich die Emitterschicht (EML) aufgeführt ist.

Die oben bzw. in den Tabellen 1 verwendeten Abkürzungen entsprechen den folgenden Verbindungen:

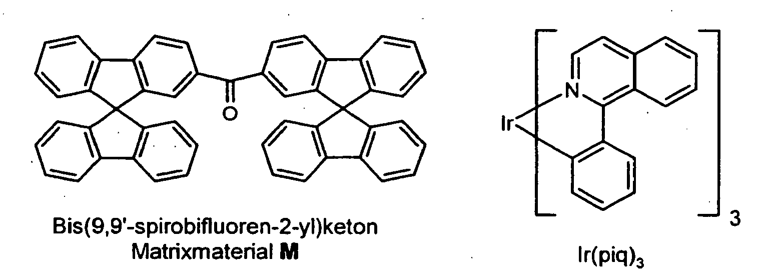

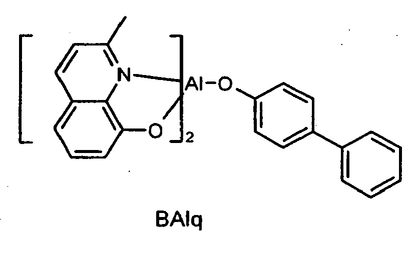

**Tabelle 1: Device-Ergebnisse mit E1 bzw. Ir(piq)₃ in M als Matrix**

| | EML | Max. Eff. [cd/A] | Spannung [V] bei 100 cd/m² | CIE (x, y) | Lebensdauer [h] bei 1000 cd/m² |
|---|---|---|---|---|---|
| Beispiel 3 (Vergleich) | **M** : 10% Ir(piq)₃ (30 nm) | 7.4 | 5.8 | 0.68 / 0.32 | 8300 |
| Beispiel 4 | **M** : 10% **E1** (30 nm) | 7.3 | 5.9 | 0.68 / 0.32 | 9100 |

Zusammenfassend kann gesagt werden, dass phosphoreszierende OLEDs, die die erfindungsgemäße Verbindung **E1** als Emitter enthalten, hohe Effizienzen und niedrige Betriebsspannungen bei gleichzeitig verbesserter Lebensdauer aufweisen, wie man leicht den in Tabelle 1 aufgeführten Beispiele entnehmen kann. Außerdem weisen diese Komplexe eine hohe thermische Stabilität auf, emittieren tiefrot und sind in wenigen Schritten in hoher Ausbeute synthetisierbar, wie dem Beispiel 1 entnommen werden kann.

## Patentansprüche

1. Verbindungen gemäß Formel (1)
M(L)ₙ(L')ₘ(L")ₒ Formel (1)
enthaltend eine Teilstruktur M(L)ₙ gemäß Formel (2), 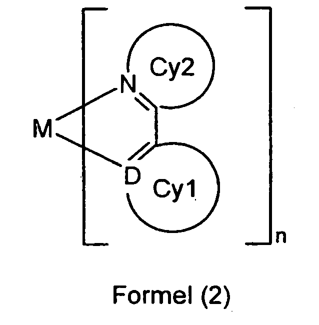 wobei für die verwendeten Symbole und Indizes gilt:
M ist ein Übergangsmetall;
D ist gleich oder verschieden bei jedem Auftreten ein sp²-hybridisiertes Kohlenstoffatom, das an M bindet, oder ein negativ geladenes Heteroatom, das an M bindet;
Cy1 ist gleich oder verschieden bei jedem Auftreten ein Homo- oder Heterocyclus, der über D an M bindet, der durch R¹ substituiert sein kann und an den noch weitere aliphatische, aromatische oder heteroaromatische Cyclen ankondensiert sein können;
Cy2 ist gleich oder verschieden bei jedem Auftreten ein Heterocyclus, der über N an M koordiniert, der durch R¹ substituiert sein kann und an den noch weitere aliphatische, aromatische oder heteroaromatische Cyclen ankondensiert sein können;
R¹ ist gleich oder verschieden bei jedem Auftreten H, F, Cl, Br, I, CN, NO₂, OH, N(R²)₂, B(OR²)₂, CHO, OSO₂R², N(Ar)₂, C(=O)Ar, P(=O)(Ar)₂, S(=O)Ar, S(=O)₂Ar, CR²=CR²Ar, eine geradkettige Alkyl-, Alkoxy- oder Thioalkoxygruppe mit 1 bis 40 C-Atomen oder eine verzweigte oder cyclische Alkyl-, Alkoxy- oder Thioalkoxygruppe mit 3 bis 40 C-Atomen, wobei jeweils eine oder mehrere nicht benachbarte CH₂-Gruppen durch -R²C=C_{R}²-, -C=C-, Si(R²)₂, Ge(R²)₂, Sn(R²)₂, -O-, -S-, -NR²-, -(C=O)-, -(C=NR²)-, -P=O(R²)-, -COOR²-, SO, SO₂ oder -CONR²- ersetzt sein können und wobei ein oder mehrere H-Atome durch F, Cl, Br, I oder CN ersetzt sein können, oder ein aromatisches oder heteroaromatisches Ringsystem bzw. eine Aryloxy- oder Heteroaryloxygruppe mit 5 bis 30 aromatischen Ringatomen, oder eine Kombination aus zwei, drei oder vier dieser Gruppen; dabei können auch zwei oder mehrere Reste R¹ miteinander ein weiteres aliphatisches, aromatisches oder heteroaromatisches Ring-system bilden;
Ar ist bei jedem Auftreten gleich oder verschieden ein aromatisches oder heteroaromatisches Ringsystem mit 5 bis 30 aromatischen Ringatomen, das mit einem oder mehreren nicht-aromatischen Resten R¹ substituiert sein kann; dabei können auch zwei Reste Ar am selben Stickstoffatom durch eine Einfachbindung oder eine Brücke O, S, N(R²) oder C(R²)₂ miteinander verknüpft sein;
R² ist gleich oder verschieden bei jedem Auftreten H oder ein aliphatischer oder aromatischer Kohlenwasserstoffrest mit 1 bis 20 C-Atomen; dabei können mehrere Reste R² auch miteinander ein Ringsystem bilden;
n ist 1, 2 oder 3;
dabei sind L' und L" in Formel (1) monoanionische, zweizähnig chelatisierende Liganden; m und o sind gleich oder verschieden bei jedem Auftreten 0, 1 oder 2;
**dadurch gekennzeichnet, dass** der Cyclus Cy2 teilweise gesättigt ist und mindestens einen Sechsring darstellt.

2. Verbindungen gemäß Formel (3), 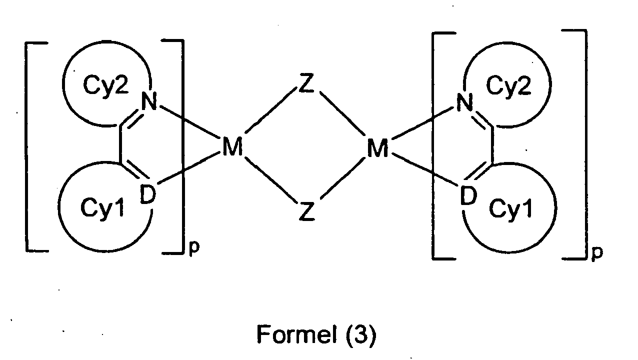 wobei die Symbole M, D, Cy1, Cy2, R¹ und R² dieselbe Bedeutung haben, wie in Anspruch 1 beschrieben, und für die weiteren Symbole und Indizes gilt:
Z ist bei jedem Auftreten gleich oder verschieden F, CI, Br, I, OH oder OR²;
p ist 2 für ein oktaedrisch koordiniertes Metall M und ist 1 für ein quadratisch-planar koordiniertes Metall M;
**dadurch gekennzeichnet, dass** der Cyclus Cy2 teilweise gesättigt ist und mindestens einen Sechsring darstellt.

3. Verbindungen nach Anspruch 1 oder 2, **dadurch gekennzeichnet, dass** Cy1 ein aromatisches oder heteroaromatisches System darstellt.

4. Verbindungen nach einem oder mehreren der Ansprüche 1 bis 3, enthaltend eine Teilstruktur M(L)ₙ gemäß Formel (2a) oder Formel (2b), 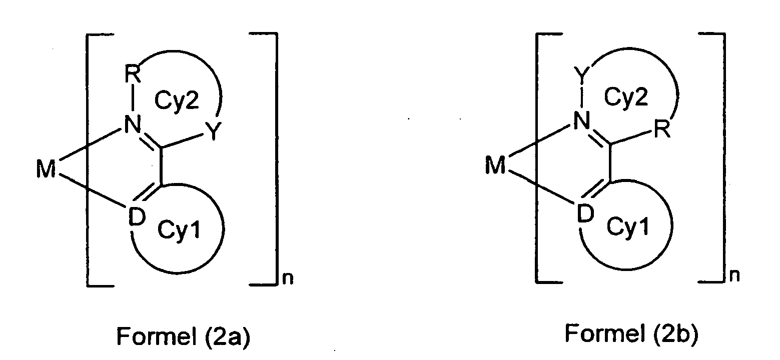 wobei M, Cyl, R¹, R², L', L", n, m und o dieselbe Bedeutung haben, wie in Anspruch 1 beschrieben, und für die weiteren Symbole gilt:
Y ist gleich oder verschieden bei jedem Auftreten C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ oder C(R¹)₂-C(R¹)₂-N(R¹);
Cy2 ist gleich oder verschieden bei jedem Auftreten ein Heterocyclus, der über N an M koordiniert, und stellt einen Sechsring oder einen Siebenring dar;
D ist bei jedem Auftreten gleich oder verschieden ein sp²-hybridisiertes C-Atom, das an M bindet, oder ein negativ geladenes Stickstoffatom, das an M bindet;
R ist gleich oder verschieden bei jedem Auftreten N(R¹), O, S, eine geradkettige bivalente Alkyl- oder Alkoxygruppe mit 1 bis 40 C-Atomen oder eine verzweigte oder cyclische bivalente Alkyl- oder Alkoxygruppe mit 3 bis 40 C-Atomen, wobei jeweils eine oder mehrere nicht benachbarte CH₂-Gruppen durch -R²C=CR²-, -C=C-, Si(R²)₂, Ge(R²)₂, Sn(R²)₂, -O-, -S-, -NR²-, -(C=O)-, -(C=NR²)-, -P=O(R²)-, -COOR²-, SO, SO₂ oder -CONR²- ersetzt sein können und wobei ein oder mehrere H-Atome durch F, Cl, Br, I oder CN ersetzt sein können, oder ein bivalentes aromatisches oder heteroaromatisches Ringsystem bzw. eine bivalente Aryloxy- oder Heteroaryloxygruppe mit 5 bis 30 aromatischen Ringatomen, oder eine Kombination aus zwei, drei oder vier dieser Systeme.

5. Verbindungen der Formel (1a) nach einem oder mehreren der Ansprüche 1 bis 4,
M(L)ₙ(L')ₘ(L")ₒ Formel (1a)
enthaltend mindestens eine Teilstruktur M(L)ₙ der Formel (2c), (2d), (2e) oder (2f), 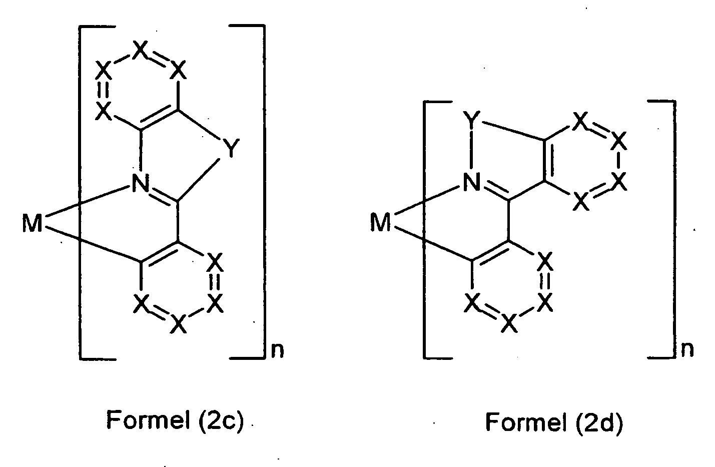 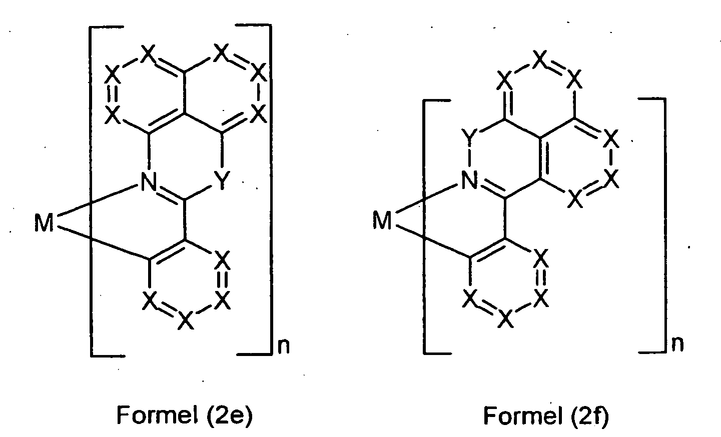 und gegebenenfalls enthaltend eine Teilstruktur M(L')ₘ der Formel (4), 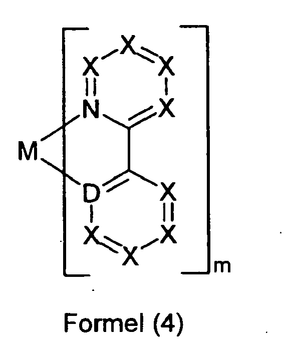 wobei M, D, Y, R¹, R², L", n, m und o dieselbe Bedeutung haben, wie in Anspruch 1 beschrieben, und weiterhin gilt:
Y ist gleich oder verschieden bei jedem Auftreten C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂. C(R¹)₂-C(R¹)₂-O, C(R¹)₂-N(R¹)-C(R¹)₂ oder C(R¹)₂-C(R¹)₂-N(R¹) für Formel (2c) und (2d); und ist gleich oder verschieden bei jedem Auftreten C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O. C(R¹)₂-N(R¹)-C(R¹)₂ oder C(R¹)₂-C(R¹)₂-N(R¹) für Formel (2e) und (2f);
X ist gleich oder verschieden bei jedem Auftreten CR¹, N oder P;
oder (X-X) bzw. (X=X) (also zwei benachbarte X)
steht für NR¹, S oder O; mit der Maßgabe, dass jeder der Cyclen, die Gruppen X enthalten, einen Fünf- oder einen Sechsring darstellt.

6. Verbindungen nach einem oder mehreren der Ansprüche 1 bis 5, **dadurch gekennzeichnet, dass** monoanionische, zweizähnige Liganden L" ausgewählt sind aus 1,3-Diketonaten abgeleitet von 1,3-Diketonen, 3-Ketonaten abgeleitet von 3-Ketoestern, Carboxylaten abgeleitet von Aminocarbonsäuren, Salicyliminaten abgeleitet von Salicyliminen, sowie Boraten Stickstoff-haltiger Heterocyclen und Liganden, die über zwei Stickstoffatome binden, wovon eines neutral und das andere negativ geladen ist.

7. Verbindungen nach einem oder mehreren der Ansprüche 1 bis 6, **dadurch gekennzeichnet, dass** M für Iridium, Platin, Palladium, Gold, Wolfram, Rhenium, Ruthenium oder Osmium steht.

8. Verbindungen nach einem oder mehreren der Ansprüche 1 bis 7, **dadurch gekennzeichnet, dass** das Symbol D = C ist.

9. Verbindungen nach einem oder mehreren der Ansprüche 1 bis 8, **dadurch gekennzeichnet, dass** das Symbol R¹ für aufdampfbare Systeme bei jedem Auftreten gleich oder verschieden H, F, CN, Methyl, tert-Butyl, Phenyl, para-Tolyl, para-Xylyl, CF₃ oder eine ankondensierte cyclische Alkyl- oder Alkoxygruppe mit 1 bis 4 C-Atomen ist oder dass R¹ für aus Lösung verarbeitete Systeme für eine Alkyl- oder Alkoxygruppe mit bis zu 10 C-Atomen steht.

10. Verwendung von Liganden, die im Komplex zu Teilstrukturen gemäß Formel (2) bzw. Formel (2a) bis Formel (2f) führen, zur Herstellung von Verbindungen nach einem oder mehreren der Ansprüche 1 bis 9.

11. Verfahren zur Herstellung der Metallkomplex-Verbindungen nach einem oder mehreren der Ansprüche 1 bis 9 durch Umsetzung von Liganden, die im Komplex zu Strukturen gemäß Formel (2) bzw. (2a) bis (2f) führen mit Metallalkoholaten der Formel (6), mit Metallketoketonaten der Formel (7) oder ein- oder mehrkernigen Metallhalogeniden der Formel (8), (9) oder (10), 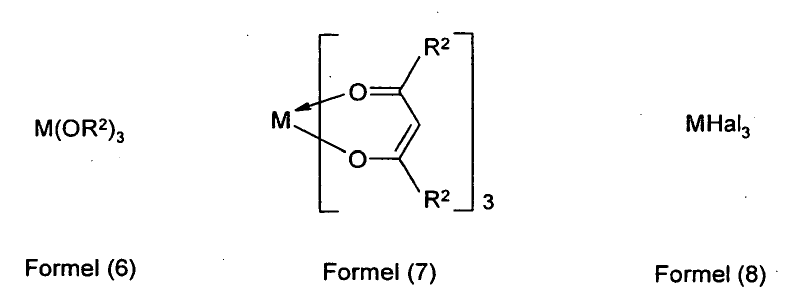 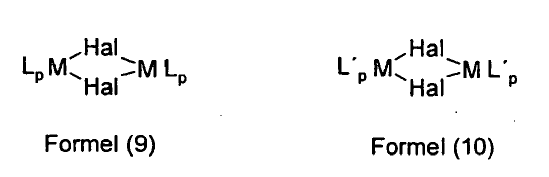 wobei die Symbole M, R¹ und p die oben angegebenen Bedeutungen haben und Hal = F, Cl, Br oder I ist, oder durch Umsetzung mit Metallverbindungen, die sowohl Alkoholat- und/oder Halogenid- und/oder Hydroxy- wie auch Ketoketonatreste tragen.

12. Verbindungen gemäß Formel (1b) nach einem oder mehreren der Ansprüche 1 bis 9,
M(L)ₙ(L')ₘ(L")ₒ Formel (1b)
enthaltend eine Teilstruktur M(L)ₙ gemäß Formel (2g), 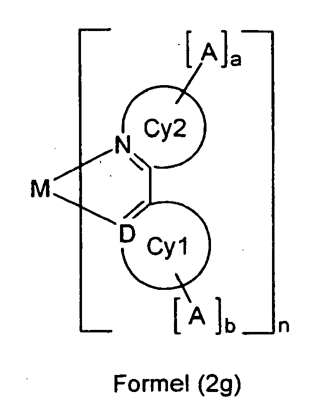 wobei M, D, Cy1, Cy2, R¹, R², L', L", n, m und o dieselbe Bedeutung haben, wie in Anspruch 1 beschrieben, und weiterhin gilt:
A ist bei jedem Auftreten gleich oder verschieden eine Gruppe, die unter Palladium- oder Nickelkatalyse zu einer C-C- oder C-N-Kupplungsreaktion befähigt ist;
a, b ist bei jedem Auftreten gleich oder verschieden 0, 1, 2 oder 3, wobei a + b mindestens gleich 1 ist.

13. Oligomere, Polymere oder Dendrimere, enthaltend eine oder mehrere Einheiten nach einem oder mehreren der Ansprüche 1 bis 9, wobei mindestens einer der oben definierten Reste R¹ bzw. R² eine Bindung zum Polymer, Oligomer oder Dendrimer darstellt.

14. Oligomere, Polymere oder Dendrimere nach Anspruch 13, **dadurch gekennzeichnet, dass** weitere Comonomere ausgewählt sind aus der Gruppe bestehend aus Fluorenen, Spirobifluorenen, Dihydrophenanthrenen, Indenofluorenen, Phenanthrenen, Para-phenylenen oder auch aus mehreren verschiedenen dieser Einheiten.

15. Verwendung von Verbindungen, Oligomeren, Polymeren und Dendrimeren nach einem oder mehreren der Ansprüche 1 bis 9 oder 13 bis 14 in elektronischen Bauteilen.

16. Elektronische Bauteile, ausgewählt aus der Gruppe der organischen und polymeren Elektrolumineszenzvorrichtungen (OLEDs, PLEDs), organischen Feld-Effekt-Transistoren (O-FETs), organischen Dünnfilmtransistoren (O-TFTs), organischen lichtemittierenden Transistoren (O-LETs), organischen integrierten Schaltungen (O-ICs), organischen Solarzellen (O-SCs), organischen Feld-Quench-Devices (O-FQDs), lichtemittierenden elektrochemischen Zellen (LECs), organische Photorezeptoren (O-PCs) und organischen Laserdioden (O-Laser), enthaltend mindestens eine Verbindung, Oligomer, Polymer oder Dendrimer einem oder mehreren der Ansprüche 1 bis 9 oder 13 bis 14.

17. Organische Elektrolumineszenzvorrichtung nach Anspruch 16, **dadurch gekennzeichnet, dass** die Verbindung gemäß mindestens einem der vorhergehenden Ansprüche in einer emittierenden Schicht zusammen mit einem Matrixmaterial eingesetzt wird.

## Claims

1. Compounds of the formula (1)
M(L)ₙ(L')ₘ(L")ₒ formula (1)
containing a moiety M(L)ₙ of the formula (2) 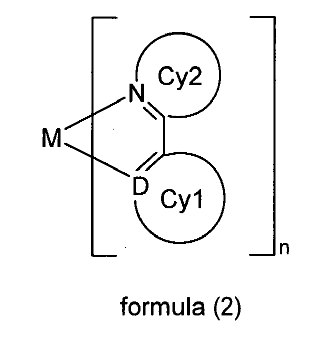 where the following applies to the symbols and indices used:
M is a transition metal;
D is, identically or differently on each occurrence, an sp²-hybridised carbon atom which bonds to M, or a negatively charged heteroatom which bonds to M;
Cy1 is, identically or differently on each occurrence, a homo- or heterocycle which bonds to M via D, may be substituted by R¹ and to which further aliphatic, aromatic or heteroaromatic rings may be fused;
Cy2 is, identically or differently on each occurrence, a heterocycle which coordinates to M via N, may be substituted by R¹ and to which further aliphatic, aromatic or heteroaromatic rings may be fused;
R¹ is, identically or differently on each occurrence, H, F, Cl, Br, I, CN, NO₂, OH, N(R²)₂, B(OR²)₂, CHO, OSO₂R², N(Ar)₂, C(=O)Ar, P(=O)(Ar)₂, S(=O)Ar, S(=O)₂Ar, CR²=CR²Ar, a straight-chain alkyl, alkoxy or thioalkoxy group having 1 to 40 C atoms or a branched or cyclic alkyl, alkoxy or thioalkoxy group having 3 to 40 C atoms, where in each case one or more non-adjacent CH₂ groups may be replaced by -R²C=CR²-, -C=C-, Si(R²)₂, Ge(R²)₂, Sn(R²)₂, -O-, -S-, -NR²-, -(C=O)-, -(C=NR²)-, -P=O(R²)-, -COOR²-, SO, SO₂ or -CONR²- and where one or more H atoms may be replaced by F, Cl, Br, I or CN, or an aromatic or heteroaromatic ring system or an aryloxy or heteroaryloxy group having 5 to 30 aromatic ring atoms, or a combination of two, three or four of these groups; two or more radicals R¹ here may also form a further aliphatic, aromatic or heteroaromatic ring system with one another;
Ar is on each occurrence, identically or differently, an aromatic or heteroaromatic ring system having 5 to 30 aromatic ring atoms, which may be substituted by one or more non-aromatic radicals R¹; two radicals Ar on the same nitrogen atom may also be linked to one another here by a single bond or an O, S, N(R²) or C(R²)₂ bridge;
R² is, identically or differently on each occurrence, H or an aliphatic or aromatic hydrocarbon radical having 1 to 20 C atoms; a plurality of radicals R² here may also form a ring system with one another;
n is 1, 2 or 3;
L' and L" in formula (1) are monoanionic, bidentate-chelating ligands; m and o are, identically or differently on each occurrence, 0, 1 or 2;
**characterised in that** the ring Cy2 is partially saturated and represents an at least six-membered ring.

2. Compounds of the formula (3) 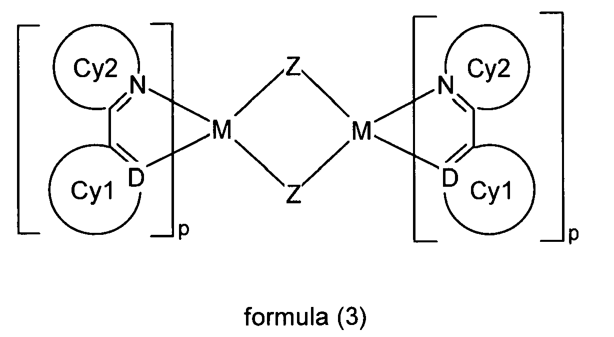 where the symbols M, D, Cy1, Cy2, R¹ and R² have the same meaning as described in Claim 1, and the following applies to the other symbols and indices:
Z is on each occurrence, identically or differently, F, Cl, Br, I, OH or OR²;
p is 2 for a metal M coordinated in an octahedral manner and is 1 for a metal M coordinated in a square-planar manner;
**characterised in that** the ring Cy2 is partially saturated and represents an at least six-membered ring.

3. Compounds according to Claim 1 or 2, **characterised in that** Cy1 represents an aromatic or heteroaromatic system.

4. Compounds according to one or more of Claims 1 to 3, containing a moiety M(L)ₙ of the formula (2a) or formula (2b) 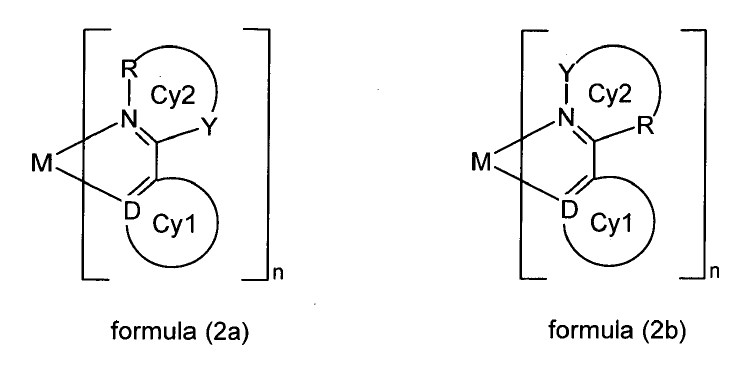 where M, Cy1, R¹, R², L', L", n, m and o have the same meaning as described in Claim 1, and the following applies to the other symbols:
Y is, identically or differently on each occurrence, C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ or C(R¹)₂-C(R¹)₂-N(R¹);
Cy2 is, identically or differently on each occurrence, a heterocycle which coordinates to M via N and represents a six-membered ring or a seven-membered ring;
D is on each occurrence, identically or differently, an sp²-hybridised C atom which bonds to M, or a negatively charged nitrogen atom which bonds to M;
R is, identically or differently on each occurrence, N(R¹), O, S, a straight-chain divalent alkyl or alkoxy group having 1 to 40 C atoms or a branched or cyclic divalent alkyl or alkoxy group having 3 to 40 C atoms, where in each case one or more non-adjacent CH₂ groups may be replaced by -R²C=CR²-, -C=C-, Si(R²)₂, Ge(R²)₂, Sn(R²)₂, -O-, -S-, -NR²-, -(C=O)-, -(C=NR²)-, -P=O(R²)-, -COOR²-, SO, SO₂ or -CONR²- and where one or more H atoms may be replaced by F, Cl, Br, I or CN, or a divalent aromatic or heteroaromatic ring system or a divalent aryloxy or heteroaryloxy group having 5 to 30 aromatic ring atoms, or a combination of two, three or four of these systems.

5. Compounds of the formula (1 a) according to one or more of Claims 1 to 4
M(L)ₙ(L')ₘ(L")ₒ formula (1a)
containing at least one moiety M(L)ₙ of the formula (2c), (2d), (2e) or (2f) 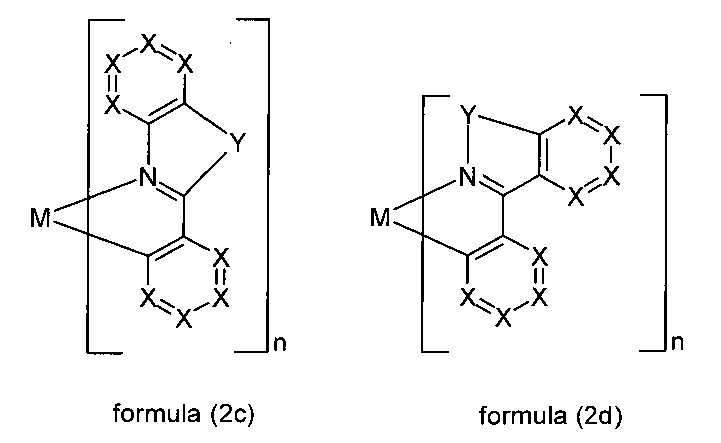 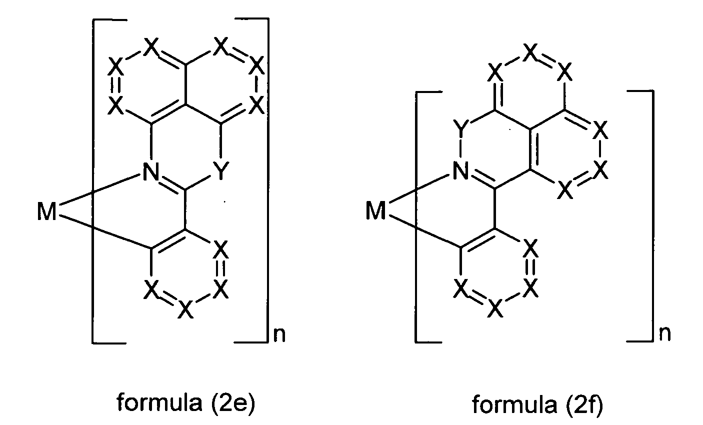 and optionally containing a moiety M(L')ₘ of the formula (4) 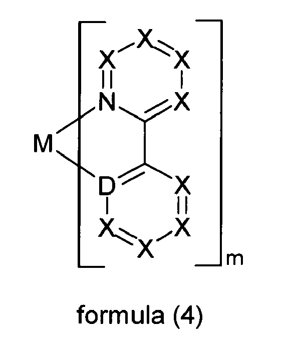 where M, D, Y, R¹, R², L", n, m and o have the same meaning as described in Claim 1, and furthermore:
Y is, identically or differently on each occurrence, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ or C(R¹)₂-C(R¹)₂-N(R¹) for formulae (2c) and (2d); and is, identically or differently on each occurrence, C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ or C(R¹)₂-C(R¹)₂-N(R¹) for formulae (2e) and (2f);
X is, identically or differently on each occurrence, CR¹, N or P;
or (X-X) or (X=X) (i.e. two adjacent X)
stands for NR¹, S or O; with the proviso that each of the rings containing groups X represents a five- or six-membered ring.

6. Compounds according to one or more of Claims 1 to 5, **characterised in that** monoanionic, bidentate ligands L" are selected from 1,3-diketonates derived from 1,3-diketones, 3-ketonates derived from 3-ketoesters, carboxylates derived from aminocarboxylic acids, salicyliminates derived from salicylimines, and borates of nitrogen-containing heterocycles, and ligands which bond via two nitrogen atoms, one of which is neutral and the other is negatively charged.

7. Compounds according to one or more of Claims 1 to 6, **characterised in that** M stands for iridium, platinum, palladium, gold, tungsten, rhenium, ruthenium or osmium.

8. Compounds according to one or more of Claims 1 to 7, **characterised in that** the symbol D = C.

9. Compounds according to one or more of Claims 1 to 8, **characterised in that** the symbol R¹ for vapour-depositable systems is on each occurrence, identically or differently, H, F, CN, methyl, tert-butyl, phenyl, para-tolyl, para-xylyl, CF₃ or a fused-on cyclic alkyl or alkoxy group having 1 to 4 C atoms, or **in that** R¹ for systems processed from solution stands for an alkyl or alkoxy group having up to 10 C atoms.

10. Use of ligands which result in moieties of the formula (2) or formula (2a) to formula (2f) in the complex for the preparation of compounds according to one or more of Claims 1 to 9.

11. Process for the preparation of the metal-complex compounds according to one or more of Claims 1 to 9 by reaction of ligands which result in structures of the formulae (2) and (2a) to (2f) in the complex with metal alkoxides of the formula (6), with metal ketoketonates of the formula (7) or mono- or polycyclic metal halides of the formula (8), (9) or (10) 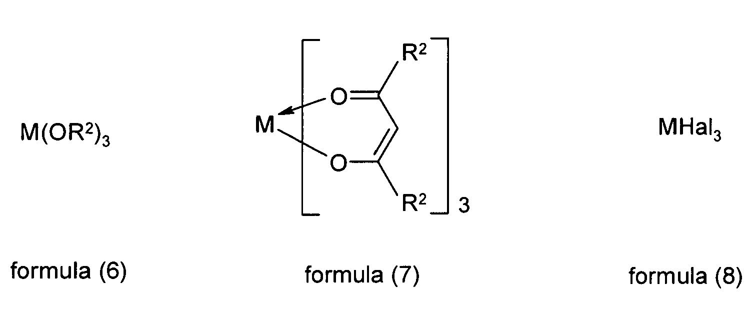 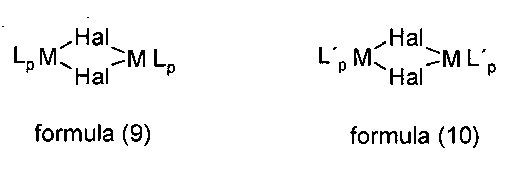 where the symbols M, R¹ and p have the meanings indicated above and Hal = F, Cl, Br or I, or by reaction with metal compounds carrying both alcoholate and/or halide and/or hydroxyl radicals as well as keto-ketonate radicals.

12. Compounds of the formula (1 b) according to one or more of Claims 1 to 9
M(L)ₙ(L')ₘ(L")ₒ formula (1b)
containing a moiety M(L)ₙ of the formula (2g) 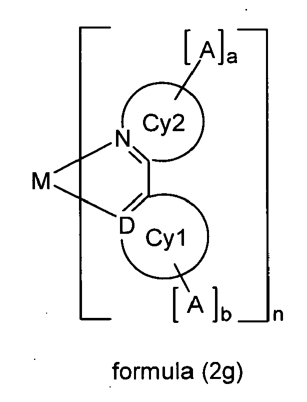 where M, D, Cy1, Cy2, R¹, R², L', L", n, m and o have the same meaning as described in Claim 1, and furthermore:
A is on each occurrence, identically or differently, a group which is capable of a C-C or C-N coupling reaction with palladium or nickel catalysis;
a, b are on each occurrence, identically or differently, 0, 1, 2 or 3, where a + b is at least equal to 1.

13. Oligomers, polymers or dendrimers containing one or more units according to one or more of Claims 1 to 9, where at least one of the radicals R¹ and R² defined above represents a bond to the polymer, oligomer or dendrimer.

14. Oligomers, polymers or dendrimers according to Claim 13, **characterised in that** further comonomers are selected from the group consisting of fluorenes, spirobifluorenes, dihydrophenanthrenes, indenofluorenes, phenanthrenes, para-phenylenes or also from a plurality of various units of these.

15. Use of compounds, oligomers, polymers and dendrimers according to one or more of Claims 1 to 9 or 13 to 14 in electronic components.

16. Electronic components selected from the group of the organic and polymeric electroluminescent devices (OLEDs, PLEDs), organic field-effect transistors (O-FETs), organic thin-film transistors (O-TFTs), organic light-emitting transistors (O-LETs), organic integrated circuits (O-ICs), organic solar cells (O-SCs), organic field-quench devices (O-FQDs), light-emitting electrochemical cells (LECs), organic photoreceptors (O-PCs) and organic laser diodes (O-lasers) comprising at least one compound, oligomer, polymer or dendrimer according to one or more of Claims 1 to 9 or 13 to 14.

17. Organic electroluminescent device according to Claim 16, **characterised in that** the compound according to at least one of the preceding claims is employed in an emitting layer together with a matrix material.

## Revendications

1. Composés de formule (1),
M(L)ₙ(L')ₘ(L")ₒ formule (1)
contenant un motif M(L)ₙ de formule (2), 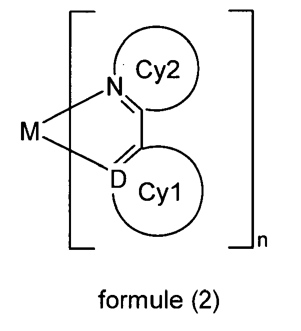 où ce qui suit s'applique aux symboles et indices utilisés :
M est un métal de transition ;
D est, de manière identique ou différente à chaque occurrence, un atome de carbone hybridé sp² qui se fixe à M, ou un hétéroatome négativement chargé qui se fixe à M ;
Cy1 est, de manière identique ou différente à chaque occurrence, un homo- ou hétérocycle qui se fixe à M par l'intermédiaire de D, peut être substitué par R¹ et sur lequel des cycles aliphatiques, aromatiques ou hétéroaromatiques supplémentaires peuvent être condensés ;
Cy2 est, de manière identique ou différente à chaque occurrence, un hétérocycle qui se coordonne à M par l'intermédiaire de N, peut être substitué par R¹ et sur lequel des cycles aliphatiques, aromatiques ou hétéroaromatiques supplémentaires peuvent être condensés ;
R¹ est, de manière identique ou différente à chaque occurrence, H, F, Cl, Br, I, CN, NO₂, OH, N(R²)₂, B(OR²)₂, CHO, OSO₂R², N(Ar)₂, C(=O)Ar, P(=O)(Ar)₂, S(=O)Ar, S(=O)₂Ar, CR²=CR²Ar, un groupement alkyle, alcoxy ou thioalcoxy à chaîne linéaire ayant de 1 à 40 atomes de C ou un groupement alkyle, alcoxy ou thioalcoxy ramifié ou cyclique ayant de 3 à 40 atomes de C, où dans chaque cas un ou plusieurs groupements CH₂ non adjacents peuvent être remplacés par -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²-, SO, SO₂ ou -CONR²- et où un ou plusieurs atomes de H peuvent être remplacés par F, Cl, Br, I ou CN, ou un système aromatique ou hétéroaromatique ou un groupement aryloxy ou hétéroaryloxy ayant de 5 à 30 atomes de cycle aromatique, ou une association de deux, trois ou quatre parmi ces groupements ; deux radicaux R¹, ou plus, peuvent ici aussi former un système aliphatique, aromatique ou hétéroaromatique supplémentaire les uns avec les autres ;
Ar est à chaque occurrence, de manière identique ou différente, un système aromatique ou hétéroaromatique ayant de 5 à 30 atomes de cycle aromatique, pouvant être substitué par un ou plusieurs radicaux R¹ non aromatiques ; deux radicaux Ar sur le même atome d'azote peuvent ici aussi être liés l'un à l'autre par une liaison simple ou un pont O, S, N(R²) ou C(R²)₂ ;
R² est, de manière identique ou différente à chaque occurrence, H ou un radical hydrocarboné aliphatique ou aromatique ayant de 1 à 20 atomes de C ; une pluralité de radicaux R² peuvent ici aussi former un noyau les uns avec les autres ;
n vaut 1, 2 ou 3 ;
L'et L" dans la formule (1) sont des ligands mono-anioniques bidentés chélateurs ; m et o sont, de manière identique ou différente à chaque occurrence, 0, 1 ou 2 ;
**caractérisés en ce que** le cycle Cy2 est partiellement saturé et représente un cycle d'au moins six chaînons.

2. Composés de formule (3), 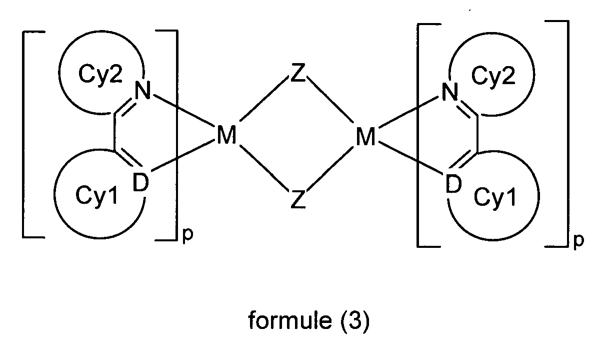 dans lesquels les symboles M, D, Cy1, Cy2, R¹ et R² ont la même signification que celle décrite selon la revendication 1, et ce qui suit s'applique aux autres symboles et indices :
Z est à chaque occurrence, de manière identique ou différente, F, Cl, Br, I, OH ou OR² ;
p vaut 2 pour un métal M coordonné de manière octaédrique et vaut 1 pour un métal M coordonné de manière carrée planaire ;
**caractérisés en ce que** le cycle Cy2 est partiellement saturé et représente un cycle d'au moins six chaînons.

3. Composés selon la revendication 1 ou 2, **caractérisés en ce que** Cy1 représente un système aromatique ou hétéroaromatique.

4. Composés selon l'une ou plusieurs des revendications 1 à 3, contenant un motif M(L)ₙ de formule (2a) ou de formule (2b), 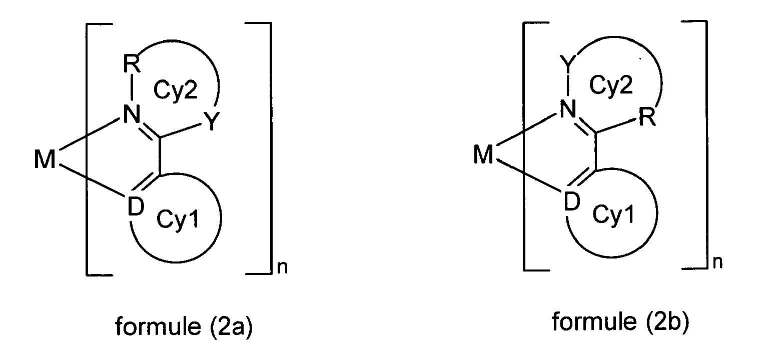 dans lesquelles M, Cy1, R¹, R², L', L", n, m et o ont la même signification que celle décrite selon la revendication 1, et ce qui suit s'applique aux autres symboles :
Y est, de manière identique ou différente à chaque occurrence, C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ ou C(R¹)₂-C(R¹)₂-N(R¹) ;
Cy2 est, de manière identique ou différente à chaque occurrence, un hétérocycle qui se coordonne à M par l'intermédiaire de N et représente un cycle à six chaînons ou à sept chaînons ;
D est à chaque occurrence, de manière identique ou différente, un atome de C hybridé sp² qui se fixe à M, ou un atome d'azote négativement chargé qui se fixe à M ;
R est, de manière identique ou différente à chaque occurrence, N(R¹), O, S, un groupement alkyle ou alcoxy divalent à chaîne linéaire ayant de 1 à 40 atomes de C ou un groupement alkyl ou alcoxy divalent ramifié ou cyclique ayant de 3
to 40 atomes de C, où dans chaque cas un ou plusieurs groupements CH₂ non adjacents peuvent être remplacés par -R²C=CR²-, -C≡C-, Si(R²)₂, Ge(R²)₂, Sn(R²)₂, -O-, -S-, -NR²-, -(C=O)-, -(C=NR²)-, -P=O(R²)-, -COOR²-, SO, SO₂ ou -CONR²- et où un ou plusieurs atomes de H peuvent être remplacés par F, Cl, Br, I ou CN, ou un système aromatique ou hétéroaromatique divalent ou un groupement aryloxy ou hétéroaryloxy divalent ayant de 5 à 30 atomes de cycle aromatique, ou une association de deux, trois ou quatre parmi ces systèmes.

5. Composés de formule (1a) selon l'une ou plusieurs des revendications 1 à 4,
M(L)ₙ(L')ₘ(L")ₒ formule (1a)
contenant au moins un motif M(L)ₙ de formule (2c), (2d), (2e) ou (2f), 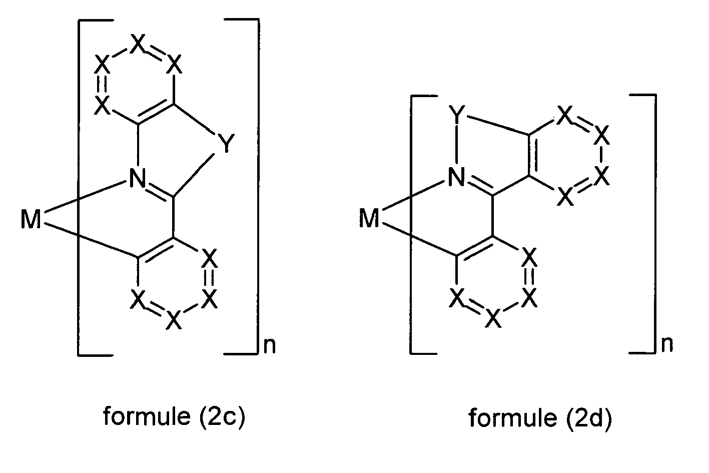 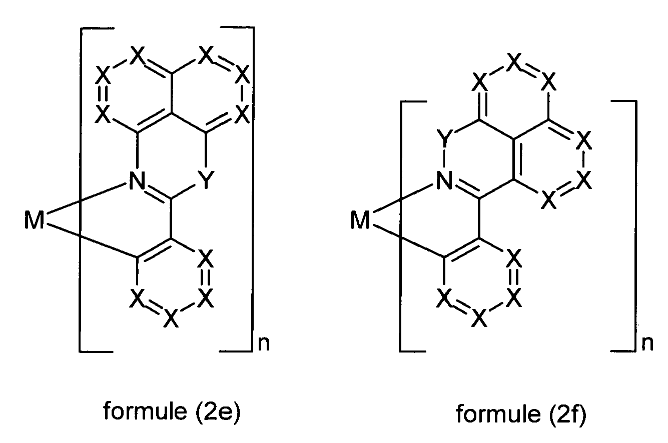 et contenant éventuellement un motif M(L')ₘ de formule (4), 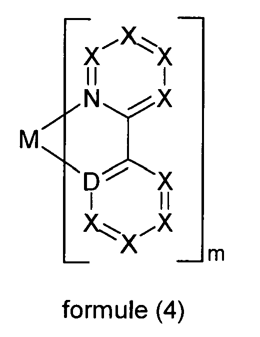 dans lesquelles M, D, Y, R¹, R², L", n, m et o ont la même signification que celle décrite selon la revendication 1, et en outre :
Y est, de manière identique ou différente à chaque occurrence, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ ou C(R¹)₂-C(R¹)₂-N(R¹) pour les formules (2c) et (2d) ; et est, de manière identique ou différente à chaque occurrence, C(R¹)₂, Si(R¹)₂, SO₂, P(=O)(R¹), C=O, C(R¹)₂-C(R¹)₂, C(R¹)₂-O, C(R¹)₂-N(R¹), C(=O)-C(R¹)₂, C(=O)-O, C(=O)-N(R¹), C(R¹)₂-C(R¹)₂-C(R¹)₂, C(R¹)₂-O-C(R¹)₂, C(R¹)₂-C(R¹)₂-O, C(R¹)₂-N(R¹)-C(R¹)₂ ou C(R¹)₂-C(R¹)₂-N(R¹) pour les formules (2e) et (2f) ;
X est, de manière identique ou différente à chaque occurrence, CR¹, N ou P ;
ou (X-X) ou (X=X) (c'est-à-dire deux X adjacents) représente NR¹, S ou O ; à condition que chacun des cycles contenant des groupements X représente un cycle de cinq ou six chaînons.

6. Composés selon l'une ou plusieurs des revendications 1 à 5, **caractérisés en ce que** les ligands mono-anioniques bidentés L" sont choisis parmi les 1,3-dicétonates dérivés de 1,3-dicétones, les 3-cétonates dérivés de 3-cétoesters, les carboxylates dérivés d'acides amino-carboxyliques, les salicyliminates dérivés de salicylimines, et les borates d'hétérocycles azotés, et les ligands qui se fixent par l'intermédiaire de deux atomes d'azote, l'un d'entre eux étant neutre et l'autre étant négativement chargé.

7. Composés selon l'une ou plusieurs des revendications 1 à 6, **caractérisés en ce que** M représente l'iridium, le platine, le palladium, l'or, le tungstène, le rhénium, le ruthénium ou l'osmium.

8. Composés selon l'une ou plusieurs des revendications 1 à 7, **caractérisés en ce que** le symbole D = C.

9. Composés selon l'une ou plusieurs des revendications 1 à 8, **caractérisés en ce que** le symbole R¹ pour les systèmes de métallisation sous vide est à chaque occurrence, de manière identique ou différente, H, F, CN, méthyle, tertio-butyle, phényle, para-tolyle, paraxylyle, CF₃ ou un groupement alkyle ou alcoxy cyclique condensé ayant de 1 à 4 atomes de C, ou **en ce que** R¹ pour les systèmes traités à partir d'une solution représente un groupement alkyle ou alcoxy ayant jusqu'à 10 atomes de C.

10. Utilisation de ligands résultant en motifs de formule (2) ou de formule (2a) à la formule (2f) dans le complexe pour la préparation de composés selon l'une ou plusieurs des revendications 1 à 9.

11. Procédé de préparation de composés de complexe métallique selon l'une ou plusieurs des revendications 1 à 9 par réaction de ligands résultant en structures de formules (2) et (2a) à (2f) dans le complexe avec des alkylates métalliques de formule (6), avec des cétocétonates métalliques de formule (7) ou des halogénures métalliques mono- ou polycycliques de formule (8), (9) ou (10), 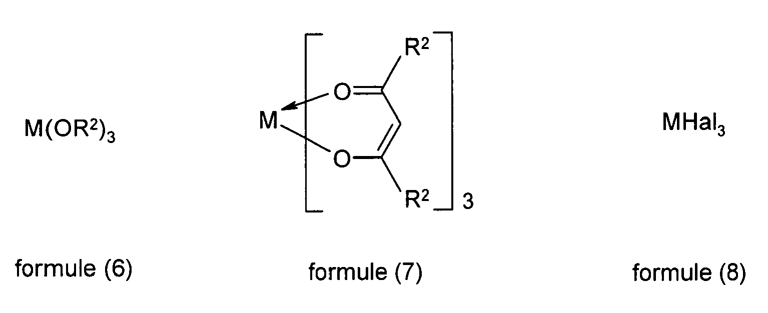 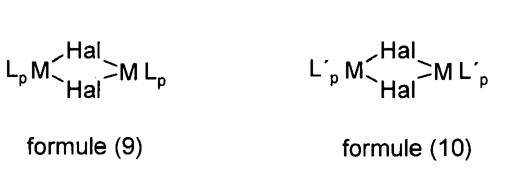 dans lesquelles les symboles M, R¹ et p ont les significations indiquées ci-dessus et Hal = F, Cl, Br ou I, ou par réaction avec des composés métalliques portant des radicaux alcoolate et/ou halogénure et/ou hydroxyle ainsi que des radicaux cétocétonates.

12. Composés de formule (1b) selon l'une ou plusieurs des revendications 1 à 9,
M(L)ₙ(L')ₘ(L")ₒ formule (1b)
contenant un motif M(L)ₙ de formule (2g), 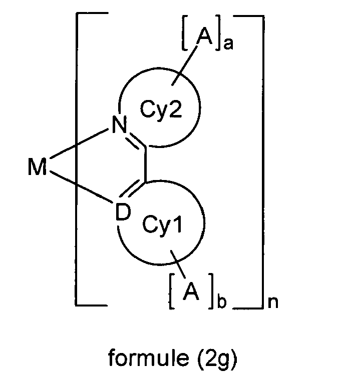 dans lesquelles M, D, Cy1, Cy2, R¹, R², L', L", n, m et o ont la même signification que celle décrite selon la revendication 1, et en outre :
A est à chaque occurrence, de manière identique ou différente, un groupement qui est apte à une réaction de couplage C-C ou C-N avec catalyse par du palladium ou du nickel ;
a, b sont à chaque occurrence, de manière identique ou différente, 0, 1, 2 ou 3, où a + b est au moins égal à 1.

13. Oligomères, polymères ou dendrimères contenant une ou plusieurs unités selon l'une ou plusieurs des revendications 1 à 9, où au moins l'un des radicaux R¹ et R² définis ci-dessus représente une liaison avec le polymère, l'oligomère ou le dendrimère.

14. Oligomères, polymères ou dendrimères selon la revendication 13, **caractérisés en ce que** des co-monomères supplémentaires sont choisis parmi le groupe constitué par les fluorènes, les spirobifluorènes, les dihydrophénanthrènes, les indénofluorènes, les phénanthrènes, les para-phénylènes ou également parmi une pluralité de diverses unités de ceux-ci.

15. Utilisation de composés, oligomères, polymères et dendrimères selon l'une ou plusieurs des revendications 1 à 9 ou 13 à 14 dans des composants électroniques.

16. Composants électroniques choisis parmi le groupe constitué par les dispositifs électroluminescents organiques et polymères (OLED, PLED), les transistors organiques à effet de champ (O-FET), les transistors organiques à couches minces (O-TFT), les transistors organiques électroluminescents (O-LET), les circuits intégrés organiques (O-IC), les cellules solaires organiques (O-SC), les dispositifs organiques de coupure de champ (O-FQD), les cellules électrochimiques électroluminescentes (LEC), les photorécepteurs organiques (O-PC) et les diodes laser organiques (O-lasers) comprenant au moins un composé, oligomère, polymère ou dendrimère selon l'une ou plusieurs des revendications 1 à 9 ou 13 à 14.

17. Dispositif électroluminescent organique selon la revendication 16, **caractérisé en ce que** le composé selon au moins l'une des revendications précédentes est employé dans une couche émettrice conjointement avec un matériau matriciel.
